# EUROPEAN PATENT APPLICATION

(11) **EP 4 811 076 A1**
(43) Date of publication of application: **23.09.2026**
(21) Application number: 26165424.8
(22) Date of filing: 17.03.2026
(51) Int. Cl.: G06F 1/16, G06F 9/30, H05K 1/02, H10K 59/10, H10K 59/12, G09F 9/30, H10K 59/40

(54) **ELECTRONIC DEVICE**

(30) Priority: 18.03.2025 KR 20250034319
(71) Applicant: Samsung Display Co., Ltd., Yongin-si, Gyeonggi-do (KR)
(72) Inventor: LEE, Kyunghoe, Yongin-si (KR); JEONG, Hwan-Hee, Yongin-si (KR); KIM, Deokjung, Yongin-si (KR); NAM, Youngwoo, Yongin-si (KR)
(74) Representative: Marks & Clerk LLP

(57) **Abstract**

An electronic device includes: a display panel having a first area, and a second area having a higher transmittance than that of the first area, the display panel including a display layer, and a sensor layer on the display layer; and an electronic module under the display panel to overlap with the second area. The sensor layer includes: a plurality of first electrodes along a first direction; a plurality of second electrodes along a second direction crossing the first direction; a plurality of third electrodes along the first direction, and overlapping with the plurality of first electrodes; and a plurality of fourth electrodes along the second direction, and overlapping with the plurality of second electrodes. In the second area, a third electrode among the plurality of third electrodes and a fourth electrode among the plurality of fourth electrodes are insulated from each other and cross each other.

## Description

### BACKGROUND

Aspects of embodiments of the present disclosure relate to an electronic device having an improved sensing performance.

Multimedia electronic devices, such as a television, a mobile phone, a tablet computer, a notebook computer, a car navigation device, a game machine, and the like, include a display device for displaying an image. The electronic devices may include a sensor layer (e.g., an input sensor) capable of providing a touch-based input method that enables a user to intuitively and conveniently input information or instructions in an easy and simple manner, in addition to a general input method, such as a button, a keyboard, a mouse, or the like. The sensor layer may sense the user's touch or pressure. Further, pens for users who may be accustomed to inputting information using writing instruments or pens for more accurate touch inputs in specific application programs (e.g., application programs for sketching or drawing) have been increasingly demanded.

The above information disclosed in this Background section is for enhancement of understanding of the background of the present disclosure, and therefore, it may contain information that does not constitute prior art.

### SUMMARY

Embodiments of the present disclosure may be directed to an electronic device having an improved sensing performance.

According to one or more embodiments of the present disclosure, an electronic device includes: a display panel having a first area, and a second area having a higher transmittance than that of the first area, the display panel including a display layer, and a sensor layer on the display layer; and an electronic module under the display panel to overlap with the second area. The sensor layer includes: a plurality of first electrodes along a first direction; a plurality of second electrodes along a second direction crossing the first direction; a plurality of third electrodes along the first direction, and overlapping with the plurality of first electrodes; and a plurality of fourth electrodes along the second direction, and overlapping with the plurality of second electrodes. In the second area, a third electrode among the plurality of third electrodes and a fourth electrode among the plurality of fourth electrodes are insulated from each other and cross each other.

In an embodiment, the fourth electrode among the plurality of fourth electrodes may include: a plurality of patterns spaced from one another in the first direction; a first-type bridge pattern connected to two adjacent patterns among the plurality of patterns; and a second-type bridge pattern connected to two other adjacent patterns among the plurality of patterns. The first-type bridge pattern may have a shape different from a shape of the second-type bridge pattern.

In an embodiment, the first-type bridge pattern may overlap with the first area, and the second-type bridge pattern may overlap with the second area.

In an embodiment, one pattern connected to the first-type bridge pattern among the plurality of patterns may have a smaller maximum width in the second direction than that of one pattern connected to the second-type bridge pattern among the plurality of patterns.

In an embodiment, each of the plurality of first electrodes may include: a plurality of sensing patterns spaced from one another in the second direction; and a plurality of bridge patterns electrically connected to the plurality of sensing patterns. The plurality of bridge patterns may not overlap with the second area.

In an embodiment, one first electrode among the plurality of first electrodes may include: a first sensing pattern, a second sensing pattern, and a third sensing pattern spaced from one another in the second direction; a plurality of first bridge patterns connected to the first sensing pattern and the second sensing pattern, and located in the first direction; and a plurality of second bridge patterns connected to the second sensing pattern and the third sensing pattern, and located in the first direction. A number of the plurality of first bridge patterns may be greater than a number of the plurality of second bridge patterns.

In an embodiment, at least a portion of each of the second sensing pattern and the third sensing pattern may overlap with the second area.

In an embodiment, the plurality of first bridge patterns and the plurality of second bridge patterns may not overlap with the second area.

In an embodiment, each of the plurality of third electrodes may include a plurality of first divided electrodes spaced from one another in the first direction, and each of the plurality of fourth electrodes may include a plurality of second divided electrodes spaced apart from one another in the second direction. Each of first divided electrodes overlapping with the second area among the plurality of first divided electrodes may insulated from second divided electrodes overlapping with the second area among the plurality of second divided electrodes, and may cross the second divided electrodes overlapping with the second area.

In an embodiment, the third electrode among the plurality of third electrodes may include: a plurality of first divided electrode portions spaced from one another in the first direction; and a first connecting electrode portion connected to all of the plurality of first divided electrode portions, and overlapping with the second area. The fourth electrode among the plurality of fourth electrodes may include: a plurality of second divided electrode portions spaced from one another in the second direction; and a second connecting electrode portion connected to all of the plurality of second divided electrode portions, and overlapping with the second area. The first connecting electrode portion and the second connecting electrode portion may be insulated from each other and may cross each other.

In an embodiment, the sensor layer may further include: a plurality of first trace lines electrically connected to the plurality of first electrodes in a one-to-one correspondence; a plurality of second trace lines electrically connected to the plurality of second electrodes in a one-to-one correspondence; a first loop trace line connected to all of the plurality of third electrodes; a plurality of second loop trace lines electrically connected to the plurality of third electrodes; and an auxiliary trace line connected to the plurality of fourth electrodes.

In an embodiment, each of the plurality of first electrodes, the plurality of second electrodes, the plurality of third electrodes, and the plurality of fourth electrodes may include a first mesh structure overlapping with the first area, and a second mesh structure overlapping with the second area. The first mesh structure may have a higher density than that of the second mesh structure.

In an embodiment, the display layer may include a plurality of emissive areas. The plurality of emissive areas may include a plurality of first-type emissive areas overlapping with the first area, and a plurality of second-type emissive areas overlapping with the second area. The first mesh structure may include a plurality of first openings overlapping with the plurality of first-type emissive areas in a one-to-one correspondence. The second mesh structure may include a plurality of second openings, and a plurality of transmissive openings. Each of the plurality of second openings may overlap with n second-type emissive areas among the plurality of second-type emissive areas, where n may be an integer of 1 or more.

According to one or more embodiments of the present disclosure, an electronic device includes: a display panel having a first area, and a second area having a higher transmittance than that of the first area, the display panel including a display layer, and a sensor layer on the display layer; and a processor configured to control an operation of the display panel. The sensor layer includes: a first electrode overlapping with the first area and the second area; a second electrode crossing the first electrode, and overlapping with the first area and the second area; a third electrode overlapping with the first electrode, and overlapping with the first area and the second area; and a fourth electrode crossing the third electrode, and overlapping with the first area and the second area. The first electrode includes: a first sensing pattern; a second sensing pattern; a third sensing pattern; a plurality of first bridge patterns connected to the first sensing pattern and the second sensing pattern, and located in a first direction; and a plurality of second bridge patterns connected to the second sensing pattern and the third sensing pattern, and located in the first direction. A number of the plurality of first bridge patterns is greater than a number of the plurality of second bridge patterns.

In an embodiment, at least a portion of each of the second sensing pattern and the third sensing pattern may overlap with the second area, and the plurality of first bridge patterns and the plurality of second bridge patterns may not overlap with the second area.

In an embodiment, each of the first electrode, the second electrode, the third electrode, and the fourth electrode may include a first mesh structure overlapping with the first area, and a second mesh structure overlapping with the second area. The first mesh structure may have a higher density than that of the second mesh structure.

In an embodiment, the fourth electrode may include: a plurality of patterns spaced from one another in the first direction; a first-type bridge pattern connected to two adjacent patterns among the plurality of patterns; and a second-type bridge pattern connected to two other adjacent patterns among the plurality of patterns. The first-type bridge pattern may have a shape different from a shape of the second-type bridge pattern.

In an embodiment, the first-type bridge pattern may overlap with the first area, and the second-type bridge pattern may overlap with the second area. One pattern connected to the first-type bridge pattern among the plurality of patterns may have a smaller maximum width in a second direction crossing the first direction than that of one pattern connected to the second-type bridge pattern among the plurality of patterns.

In an embodiment, the third electrode may include: a plurality of first divided electrode portions spaced from one another in the first direction; and a first connecting electrode portion connected to all of the plurality of first divided electrode portions, and overlapping with the second area. The fourth electrode may include: a plurality of second divided electrode portions spaced from one another in a second direction crossing the first direction; and a second connecting electrode portion connected to all of the plurality of second divided electrode portions, and overlapping with the second area. The first connecting electrode portion and the second connecting electrode portion may be insulated from each other and may cross each other.

In an embodiment, the third electrode may include X first divided electrodes spaced from one another in the first direction, where X may be an integer of 2 or more. The fourth electrode may include Y second divided electrodes spaced from one another in a second direction crossing the first direction, where Y may be an integer of 2 or more. In X * Y intersection areas, the third electrode and the fourth electrode may be insulated from each other and may cross each other.

However, the present disclosure is not limited to the above aspects and features, and the above and additional aspects and features will be set forth, in part, in the detailed description that follows with reference to the drawings, and in part, may be apparent therefrom, or may be learned by practicing one or more of the presented embodiments of the present disclosure.

At least some of the above and other features of the invention are set out in the claims.

### BRIEF DESCRIPTION OF THE FIGURES

The above and other aspects and features of the present disclosure will be more clearly understood from the following detailed description of the illustrative, nonlimiting embodiments with reference to the accompanying drawings.
FIG. 1 is a block diagram of an electronic device according to an embodiment.
FIG. 2A is a front perspective view of an electronic device according to an embodiment of the present disclosure.
FIG. 2B is a rear perspective view of an electronic device according to an embodiment of the present disclosure.
FIG. 3 is a perspective view of an electronic device according to an embodiment of the present disclosure.
FIG. 4 is a perspective view of an electronic device according to an embodiment of the present disclosure.
FIG. 5 is a schematic sectional view of a display panel according to an embodiment of the present disclosure.
FIG. 6 is a view illustrating an operation of an electronic device according to an embodiment of the present disclosure.
FIG. 7A is a sectional view of a display panel according to an embodiment of the present disclosure.
FIG. 7B is a sectional view illustrating some components of a sensor layer according to an embodiment of the present disclosure.
FIG. 8 is a plan view of a sensor layer according to an embodiment of the present disclosure.
FIG. 9A is a plan view illustrating a first conductive layer of a sensing unit according to an embodiment of the present disclosure.
FIG. 9B is a plan view illustrating a second conductive layer of a sensing unit according to an embodiment of the present disclosure.
FIG. 10 is an enlarged plan view of the area AA' illustrated in FIG. 9B.
FIG. 11A is a plan view illustrating a portion of a first conductive layer of a sensor layer according to an embodiment of the present disclosure.
FIG. 11B is a plan view illustrating a portion of a second conductive layer of a sensor layer according to an embodiment of the present disclosure.
FIG. 12 is a plan view illustrating some components of a sensor layer according to an embodiment of the present disclosure.
FIG. 13 is an enlarged plan view of the area BB' illustrated in FIG. 11A.
FIG. 14 is an enlarged plan view of the area CC' illustrated in FIG. 11B.
FIG. 15 is a plan view illustrating some components of a sensor layer according to an embodiment of the present disclosure.
FIG. 16 is a plan view illustrating some components of a sensor layer according to an embodiment of the present disclosure.
FIG. 17 is a view illustrating an operation of a sensor driver according to an embodiment of the present disclosure.
FIG. 18 is a view illustrating an operation of the sensor driver according to an embodiment of the present disclosure.
FIG. 19 is a view illustrating a first mode according to an embodiment of the present disclosure.
FIG. 20 is a view illustrating a second mode according to an embodiment of the present disclosure.
FIG. 21A is a graph depicting a waveform of a first signal according to an embodiment of the present disclosure.
FIG. 21B is a graph depicting a waveform of a second signal according to an embodiment of the present disclosure.
FIG. 22A is a view illustrating a second mode according to an embodiment of the present disclosure.
FIG. 22B is a view illustrating a second mode based on one sensing unit according to an embodiment of the present disclosure.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Further, it should be expected that the shapes shown in the figures may vary in practice depending, for example, on tolerances and/or manufacturing techniques. Accordingly, the embodiments of the present disclosure should not be construed as being limited to the specific shapes shown in the figures, and should be construed considering changes in shapes that may occur, for example, as a result of manufacturing. As such, the shapes shown in the drawings may not depict the actual shapes of areas of the device, and the present disclosure is not limited thereto.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the example embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

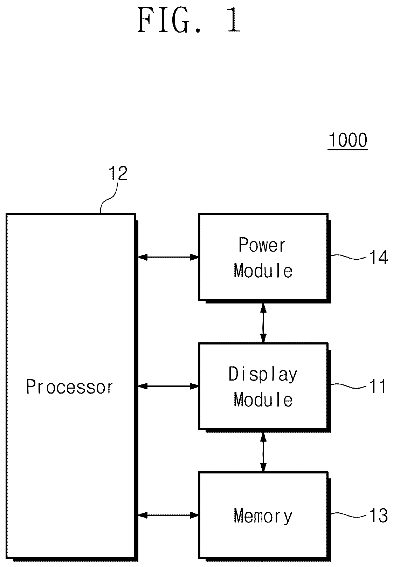

FIG. 1 is a block diagram of an electronic device 1000 according to an embodiment.

Referring to FIG. 1, the electronic device 1000 according to an embodiment may include a display module (e.g., a display or a touch-display) 11, a processor 12, a memory 13, and a power module (e.g., a power circuit or a power supply) 14.

The display module 11 may display an image. The image may include a still image as well as a dynamic image. The processor 12 may include at least one of a central processing unit (CPU), an application processor (AP), a graphic processing unit (GPU), a communication processor (CP), an image signal processor (ISP), and/or a controller. The processor 12 may control an operation of the display module 11.

Data information used for an operation of the processor 12 or the display module 11 may be stored in the memory 13. When the processor 12 executes an application stored in the memory 13, an image data signal and/or an input control signal may be transferred to the display module 11, and the display module 11 may process the provided signal to output image information through a display screen.

The power module 14 may include a power supply module, such as a power adaptor or a battery device, and a power conversion module that converts power supplied by the power supply module to generate power used for an operation of the electronic device 1000.

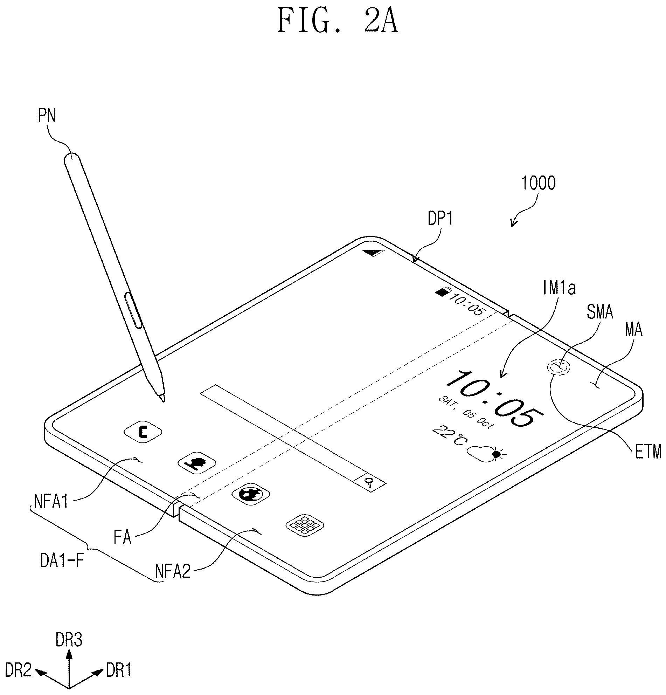

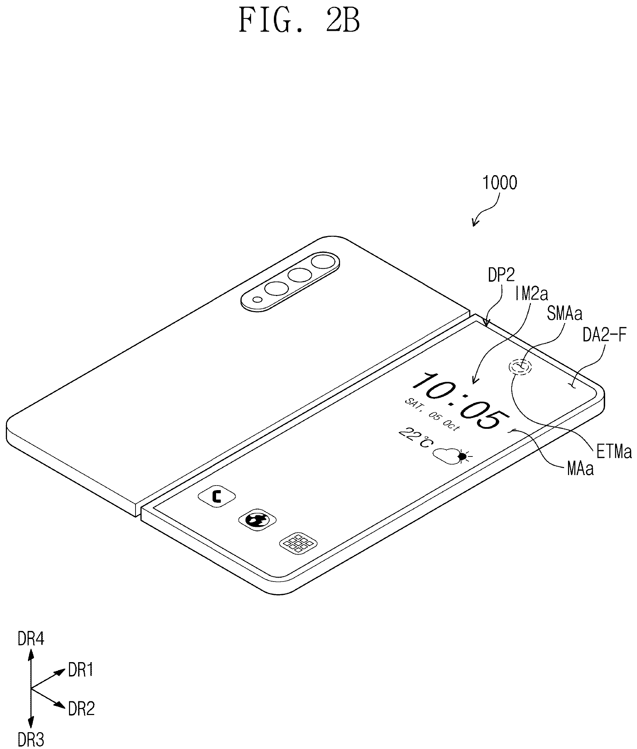

FIG. 2A is a front perspective view of the electronic device 1000 according to an embodiment of the present disclosure. FIG. 2B is a rear perspective view of the electronic device 1000 according to an embodiment of the present disclosure.

Referring to FIGS. 2A and 2B, the electronic device 1000 may be a device that is activated in response to an electrical signal. For example, the electronic device 1000 may display an image, and may sense inputs applied from the outside. The external inputs may be user inputs. The user inputs may include various suitable kinds of external inputs, such as a part of a user's body, a pen PN, light, heat, or pressure.

The electronic device 1000 may include a first display panel DP1 and a second display panel DP2. The first display panel DP1 and the second display panel DP2 may be separate panels separated from each other. The first display panel DP1 may be referred to as a main display panel, and the second display panel DP2 may be referred to as an auxiliary display panel or an external display panel.

The first display panel DP1 may include a first display DA1-F, and the second display panel DP2 may include a second display DA2-F. The second display panel DP2 may have a smaller area than that of the first display panel DP1. The area of the first display DA1-F may be greater than the area of the second display DA2-F in correspondence to the sizes of the first display panel DP1 and the second display panel DP2.

When the electronic device 1000 is in an unfolded state, the first display DA1-F may have a plane that is parallel to or substantially parallel to a first direction DR1 and a second direction DR2. The thickness direction of the electronic device 1000 may be parallel to or substantially parallel to a third direction DR3 crossing the first direction DR1 and the second direction DR2. Accordingly, front surfaces (e.g., upper surfaces) and rear surfaces (e.g., lower surfaces) of members constituting the electronic device 1000 may be defined based on the third direction DR3.

The first display panel DP1 or the first display DA1-F may include a folding area FA that may be folded and unfolded, and a plurality of non-folding areas NFA1 and NFA2 spaced apart from each other with the folding area FA therebetween. The second display panel DP2 may overlap with one of the plurality of non-folding areas NFA1 and NFA2. For example, the second display panel DP2 may overlap with the first non-folding area NFA1.

The display direction of a first image IM1a displayed on the first display panel DP1 and the display direction of a second image IM2a displayed on the second display panel DP2 may be opposite to each other. For example, the first image IM1a may be displayed in the third direction DR3, and the second image IM2a may be displayed in a fourth direction DR4 opposite to the third direction DR3.

In an embodiment of the present disclosure, the folding area FA may be bent about a folding axis extending in a direction parallel to or substantially parallel to the long sides of the electronic device 1000, for example, in a direction parallel to or substantially parallel to the first direction DR1. When the electronic device 1000 is in a folded state, the folding area FA has a suitable curvature (e.g., a certain or predetermined curvature) and a suitable radius of curvature (e.g., a certain or predetermined radius of curvature). The first non-folding area NFA1 and the second non-folding area NFA2 may face each other, and the electronic device 1000 may be folded in an inner-folding manner, such that the first display DA1-F is not exposed to the outside.

In an embodiment of the present disclosure, the electronic device 1000 may be folded in an outer-folding manner, such that the first display DA1-F is exposed to the outside. In an embodiment of the present disclosure, the electronic device 1000 may be folded in both an inner-folding manner or an outer-folding manner from the unfolded state, but the present disclosure is not limited thereto.

Although FIG. 2A illustrates an example in which one folding area FA is defined (e.g., is provided or included) in the electronic device 1000, the present disclosure is not limited thereto. For example, a plurality of folding axes and a plurality of folding areas corresponding thereto may be defined in the electronic device 1000, and from the unfolded state, the electronic device 1000 may be folded in an inner-folding manner or an outer-folding manner in each of the plurality of folding areas.

According to an embodiment of the present disclosure, at least one of the first display panel DP1 and/or the second display panel DP2 may sense an input by the pen PN even without a digitizer. Accordingly, an increase in the thickness and the weight of the electronic device 1000, and a reduction in the flexibility of the electronic device 1000 due to the addition of the digitizer may not occur, because the digitizer for sensing the pen PN may be omitted. Thus, not only the first display panel DP1, but also the second display panel DP2, may be designed to sense the pen PN.

In an embodiment of the present disclosure, the first display panel DP1 may include a first area MA and a second area SMA. The second display panel DP2 may include a first area MAa and a second area SMAa. The second area SMA may be an area having a higher transmittance than that of the first area MA. In addition, the second area SMAa may be an area having a higher transmittance than that of the first area MAa. For example, a transmissive area may be defined in the second area SMA of the first display panel DP1 and the second area SMAa of the second display panel DP2.

In an embodiment of the present disclosure, the second area SMA of the first display panel DP1 may display an image. A pixel density of the second area SMA may be lower than a pixel density of the first area MA, or a resolution of the second area SMA may be lower than a resolution of the first area MA. The second area SMAa of the second display panel DP2 may not display an image. For example, a through-hole overlapping with the second area SMAa may be defined in the second display panel DP2.

The electronic device 1000 may further include an electronic module (e.g., a sensor) ETM that is disposed under the first display panel DP1 and that overlaps with the second area SMA, and an electronic module (e.g., a sensor) ETMa that overlaps with the second area SMAa of the second display panel DP2. Each of the electronic modules ETM and ETMa may be a camera module (e.g., a camera or an image sensor), but the present disclosure is not particularly limited thereto.

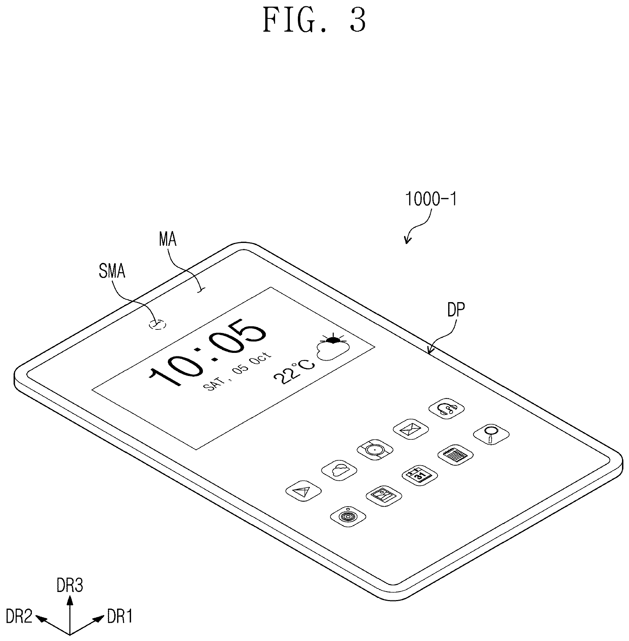

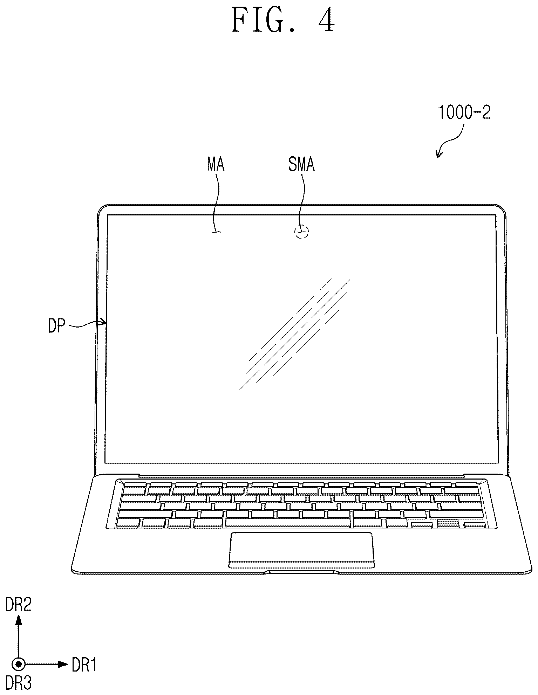

FIG. 3 is a perspective view of an electronic device 1000-1 according to an embodiment of the present disclosure. FIG. 4 is a perspective view of an electronic device 1000-2 according to an embodiment of the present disclosure.

FIG. 3 illustrates an example in which the electronic device 1000-1 is a bar-kind of mobile phone, and the electronic device 1000-1 may include a display panel DP. FIG. 4 illustrates an example in which the electronic device 1000-2 is a notebook computer, and the electronic device 1000-2 may include a display panel DP. FIG. 4 is a perspective view of the electronic device 1000-2, but the coordinate axes included in FIG. 4 are illustrated based on the display panel DP in the electronic device 1000-2.

In an embodiment of the present disclosure, the display panel DP may sense external inputs applied from the outside. The external inputs may be user inputs. The user inputs may include various suitable kinds of external inputs, such as a part of the user's body, the pen PN (e.g., refer to FIG. 2A), light, heat, or pressure.

In an embodiment of the present disclosure, the display panel DP may include a first area MA and a second area SMA. The second area SMA may be an area having a higher transmittance than that of the first area MA. The second area SMA of the display panel DP may display an image. A pixel density of the second area SMA may be lower than a pixel density of the first area MA, or a resolution of the second area SMA may be lower than a resolution of the first area MA.

According to an embodiment of the present disclosure, the display panel DP may sense an input by the pen PN even without a digitizer. Accordingly, an increase in the thickness and the weight of the electronic device 1000-1 or 1000-2 due to an addition of the digitizer may not occur, because the digitizer for sensing the pen PN may be omitted.

Although the foldable electronic device 1000 is illustrated in FIG. 2A and the bar-kind of electronic device 1000-1 is illustrated in FIG. 3, the present disclosure is not limited thereto. For example, the following description of some embodiments may be applied to various suitable electronic devices, such as a rollable electronic device, a slidable electronic device, and a stretchable electronic device.

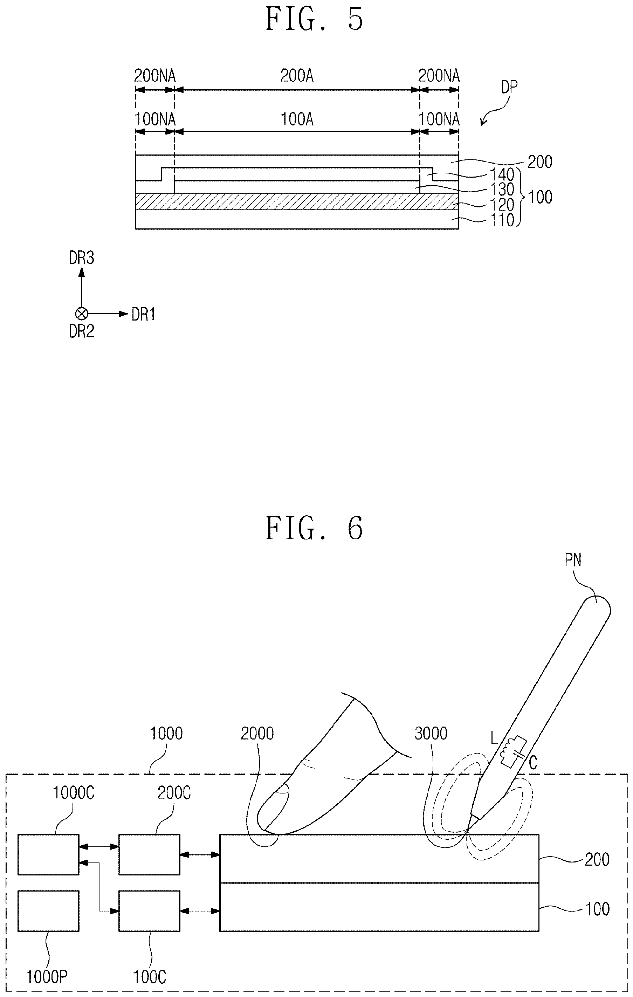

FIG. 5 is a schematic sectional view of the display panel DP according to an embodiment of the present disclosure.

Referring to FIG. 5, the display panel DP may include a display layer 100 and a sensor layer 200. An upper functional member may be additionally disposed on the sensor layer 200. For example, the upper functional member may include at least one of an anti-reflective layer, a window, and/or a protective film.

The display layer 100 may be a component that substantially generates an image. A display area 100A and a non-display area 100NA adjacent to the display area 100A may be defined in the display layer 100. The image may be displayed in the display area 100A.

The display layer 100 may be an emissive display layer. For example, the display layer 100 may be an organic light emitting display layer, an inorganic light emitting display layer, an organic-inorganic light emitting display layer, a quantum-dot display layer, a micro-LED display layer, or a nano-LED display layer. The display layer 100 may include a base layer 110, a circuit layer 120, a light emitting element layer 130, and an encapsulation layer 140.

The base layer 110 may be a member that provides a base surface on which the circuit layer 120 is disposed. The base layer 110 may have a multi-layered structure or a single-layer structure. The base layer 110 may be a glass substrate, a metal substrate, a silicon substrate, or a polymer substrate, but the present disclosure is not particularly limited thereto.

The circuit layer 120 may be disposed on the base layer 110. The circuit layer 120 may include an insulating layer, a semiconductor pattern, a conductive pattern, and a signal line. An insulating layer, a semiconductor layer, and a conductive layer may be formed on the base layer 110 by coating or deposition. The insulating layer, the semiconductor layer, and the conductive layer may be selectively subjected to patterning by performing a photolithography process a plurality of times.

The light emitting element layer 130 may be disposed on the circuit layer 120. The light emitting element layer 130 may include a light emitting element. For example, the light emitting element layer 130 may include an organic luminescent material, an inorganic luminescent material, an organic-inorganic luminescent material, a quantum dot, a quantum rod, a micro LED, or a nano-LED.

The encapsulation layer 140 may be disposed on the light emitting element layer 130. The encapsulation layer 140 may protect the light emitting element layer 130 from moisture, oxygen, and foreign matter, such as dust particles.

The sensor layer 200 may be disposed on the display layer 100. A sensing area 200A and a peripheral area 200NA adjacent to the sensing area 200A may be defined in the sensor layer 200. The sensing area 200A may overlap with the display area 100A, and the peripheral area 200NA may overlap with the non-display area 100NA.

According to an embodiment of the present disclosure, the area of the sensing area 200A may be greater than or equal to the area of the display area 100A. Although FIG. 5 illustrates an example in which the area of the sensing area 200A and the area of the display area 100A are equal to or substantially equal to each other, the present disclosure is not limited thereto. For example, a portion of the sensing area 200A may overlap with the non-display area 100NA, and the area of the sensing area 200A may be greater than the area of the display area 100A. In this case, even though an input occurs adjacent to a boundary between the display area 100A and the non-display area 100NA, a signal may be sufficiently recognized, because the sensing area 200A overlaps with a portion of the non-display area 100NA. Accordingly, a coordinate accuracy for a touch input to a periphery of the display area 100A may be further improved.

The sensor layer 200 may sense an external input applied from the outside. The sensor layer 200 may be an integrated sensor that is continuously formed in a process of manufacturing the display layer 100, or the sensor layer 200 may be an external sensor that is attached to the display layer 100. The sensor layer 200 may be referred to as a sensor, an input sensing layer, an input sensing panel, or an electronic device for sensing input coordinates.

According to an embodiment of the present disclosure, the sensor layer 200 may sense both an input by a passive input means, such as the user's body, and an input by an input device that generates a magnetic field having a suitable resonant frequency (e.g., a certain or predetermined resonant frequency). The input device may be referred to as a pen, an input pen, a magnetic pen, a stylus pen, or an electromagnetic resonance pen.

FIG. 6 is a view illustrating an operation of the electronic device 1000 according to an embodiment of the present disclosure.

Referring to FIG. 6, the electronic device 1000 may include the display layer 100, the sensor layer 200, a display driver 100C, a sensor driver 200C, a main driver 1000C, and a power circuit 1000P.

The sensor layer 200 may sense a first input 2000 or a second input 3000 applied from the outside. Each of the first input 2000 and the second input 3000 may be an input by an input means capable of changing a capacitance of the sensor layer 200, or an input by an input means capable of causing an induced current in the sensor layer 200. For example, the first input 2000 may be an input by a passive input means, such as the user's body. The second input 3000 may be an input by the pen PN, or an input by an RFIC tag. For example, the pen PN may be a passive pen or an active pen.

In an embodiment of the present disclosure, the pen PN may be a device that generates a magnetic field having a suitable resonant frequency (e.g., a certain or predetermined resonant frequency). The pen PN may transmit an output signal based on an electromagnetic resonance scheme. The pen PN may be referred to as an input device, an input pen, a magnetic pen, a stylus pen, or an electromagnetic resonance pen.

The pen PN may include an RLC resonance circuit, and the RLC resonance circuit may include an inductor L and a capacitor C. In an embodiment of the present disclosure, the RLC resonance circuit may be a variable resonance circuit that varies the resonant frequency. In this case, the inductor L may be a variable inductor, and/or the capacitor C may be a variable capacitor. However, the present disclosure is not particularly limited thereto.

The inductor L may generate a current by a magnetic field formed in the electronic device 1000, for example, such as in the sensor layer 200. However, the present disclosure is not particularly limited thereto. For example, when the pen PN operates in an active kind, the pen PN may generate a current even though a magnetic field is not provided from the outside. The generated current may be transferred to the capacitor C. The capacitor C charges the current input from the inductor L, and discharges the charged current to the inductor L. Thereafter, the inductor L may emit a magnetic field having a resonant frequency. An induced current may flow in the sensor layer 200 due to the magnetic field emitted by the pen PN. The induced current may be transferred to the sensor driver 200C as a reception signal (e.g., a sensing signal or a signal).

The main driver 1000C may control the overall operations of the electronic device 1000. For example, the main driver 1000C may control operations of the display driver 100C and the sensor driver 200C. In other words, the main driver 1000C may control operations of the display layer 100 and the sensor layer 200. The main driver 1000C may include at least one microprocessor, and may further include a graphic controller. The main driver 1000C may be referred to as an application processor, a central processing unit, or a main processor. The main driver 1000C may correspond to the processor 12 described above with reference to FIG. 1.

The display driver 100C may drive the display layer 100. The display driver 100C may receive image data and a control signal from the main driver 1000C. The control signal may include various suitable signals. For example, the control signal may include a vertical input synchronization signal, a horizontal input synchronization signal, a main clock signal, and/or a data enable signal.

The sensor driver 200C may drive the sensor layer 200. The sensor driver 200C may receive a control signal from the main driver 1000C. The control signal may include a clock signal of the sensor driver 200C. In addition, the control signal may further include a mode determination signal for determining an operation mode of the sensor driver 200C and the sensor layer 200.

The sensor driver 200C may be implemented with an integrated circuit (IC), and may be electrically connected with the sensor layer 200. For example, the sensor driver 200C may be directly mounted on a suitable area (e.g., a certain or predetermined area) of the display panel, or may be mounted on a separate printed circuit board in a chip on film (COF) manner, and electrically connected with the sensor layer 200.

The sensor driver 200C and the sensor layer 200 may selectively operate in a first mode or a second mode. For example, the first mode may be a mode for sensing a touch input, for example, such as the first input 2000. The second mode may be a mode for sensing an input by the pen PN, for example, such as the second input 3000. The first mode may be referred to as a touch sensing mode, and the second mode may be referred to as a pen sensing mode.

A transition between the first mode and the second mode may be performed in various suitable ways. For example, the sensor driver 200C and the sensor layer 200 may be driven in the first mode and the second mode in a time division manner, and may sense the first input 2000 and the second input 3000. As another example, the transition between the first mode and the second mode may occur through a selection by the user or a specific action (e.g., an input) of the user. As another example, by activation or deactivation of a specific application, one of the first mode or the second mode may be activated or deactivated, or the operation mode may be switched from one mode to the other mode. As another example, while the sensor driver 200C and the sensor layer 200 alternately operate in the first mode and the second mode, when the first input 2000 is sensed, the sensor driver 200C and the sensor layer 200 may remain in the first mode, and when the second input 3000 is sensed, the sensor driver 200C and the sensor layer 200 may remain in the second mode.

The sensor driver 200C may calculate coordinate information of an input based on a signal received from the sensor layer 200, and may provide a coordinate signal having the coordinate information to the main driver 1000C. The main driver 1000C executes an operation corresponding to the user input based on the coordinate signal. For example, the main driver 1000C may operate the display driver 100C, such that a new application image is displayed on the display layer 100.

The power circuit 1000P may include a power management integrated circuit (PMIC). The power circuit 1000P may generate a plurality of driving voltages for driving the display layer 100, the sensor layer 200, the display driver 100C, and the sensor driver 200C. For example, the plurality of driving voltages may include a gate high voltage, a gate low voltage, a first driving voltage, a second driving voltage, and/or an initialization voltage, but the present disclosure is not particularly limited thereto.

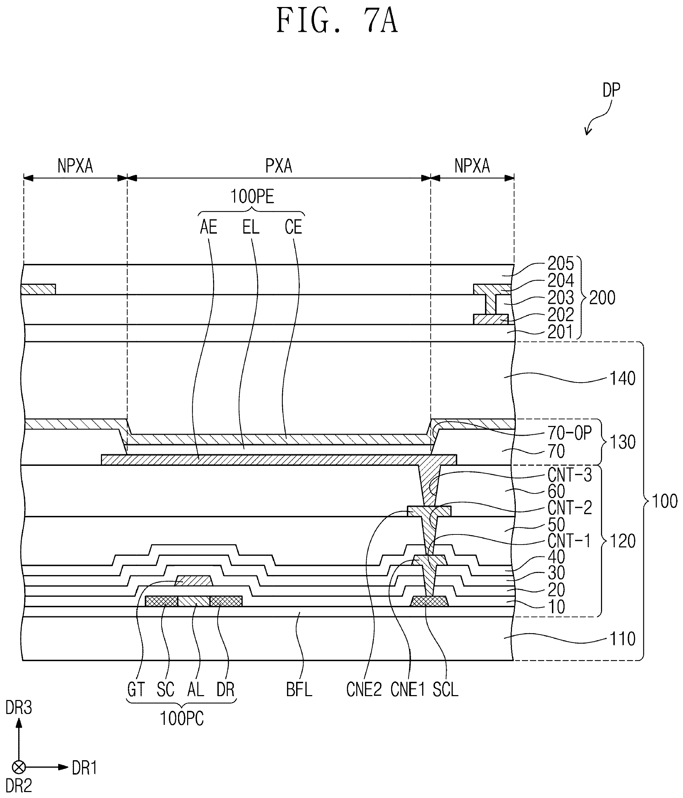

FIG. 7A is a sectional view of the display panel DP according to an embodiment of the present disclosure.

Referring to FIG. 7A, at least one buffer layer BFL may be formed on the upper surface of the base layer 110. The buffer layer BFL may improve a coupling force between the base layer 110 and a semiconductor pattern. The buffer layer BFL may be formed of multiple layers. The display layer 100 may further include a barrier layer. The buffer layer BFL may include at least one of silicon oxide, silicon nitride, and/or silicon oxy nitride. For example, the buffer layer BFL may include a multilayered structure in which silicon oxide layers and silicon nitride layers are alternately stacked one above another.

The semiconductor pattern SC, AL, DR, and SCL may be disposed on the buffer layer BFL. The semiconductor pattern SC, AL, DR, and SCL may include poly silicon. However, the present disclosure is not limited thereto, and the semiconductor pattern SC, AL, DR, and SCL may include amorphous silicon, a low-temperature polycrystalline silicon, or an oxide semiconductor.

FIG. 7A illustrates the semiconductor pattern SC, AL, DR, and SCL, and semiconductor patterns may be further disposed in other areas in another view. The semiconductor pattern SC, AL, DR, and SCL may be arranged across pixels according to a suitable rule (e.g., a specific or predetermined rule). The semiconductor pattern SC, AL, DR, and SCL may have different electrical properties depending on whether doping is performed or not. The semiconductor pattern SC, AL, DR, and SCL may include first areas SC, DR, and SCL having a higher conductivity, and a second area AL having a lower conductivity. The first areas SC, DR, and SCL may be doped with an N-type dopant or a P-type dopant. A P-type transistor may include a doped area doped with a P-type dopant, and an N-type transistor may include a doped area doped with an N-type dopant. The second area AL may be a non-doped area, or may be an area that is more lightly doped than that of the first area SC, DR, and SCL.

The first areas SC, DR, and SCL may have a higher conductivity than that of the second area AL, and may substantially serve as an electrode or a signal line. The second area AL may substantially correspond to an active area AL (e.g., a channel) of a transistor 100PC. In other words, a portion AL of the semiconductor pattern SC, AL, DR, and SCL may be the active area AL of the transistor 100PC, another portion SC or DR may be a source area SC or a drain area DR of the transistor 100PC, and another portion SCL may be a connecting electrode or a connecting signal line SCL.

Each of the pixels may have an equivalent circuit including a plurality of transistors, at least one capacitor, and at least one light emitting element, but the equivalent circuit diagram of the pixel may be variously modified as needed or desired. In FIG. 7A, one transistor 100PC and one light emitting element 100PE included in one pixel are illustrated as an example.

The source area SC, the active area AL, and the drain area DR of the transistor 100PC may be formed from the semiconductor pattern SC, AL, DR, and SCL. The source area SC and the drain area DR may extend from the active area AL in opposite directions from each other on the cross-section. In FIG. 7A, a portion of the connecting signal line SCL formed from the semiconductor pattern SC, AL, DR, and SCL is illustrated. In another view, the connecting signal line SCL may be connected to the drain area DR of the transistor 100PC when viewed from above a plane (e.g., in a plan view).

A first insulating layer 10 may be disposed on the buffer layer BFL. The first insulating layer 10 may commonly overlap with the plurality of pixels, and may cover the semiconductor pattern SC, AL, DR, and SCL. The first insulating layer 10 may be an inorganic layer and/or an organic layer, and may have a single-layer structure or a multi-layered structure. The first insulating layer 10 may include at least one of aluminum oxide, titanium oxide, silicon oxide, silicon nitride, silicon oxy nitride, zirconium oxide, and/or hafnium oxide. In the present embodiment, the first insulating layer 10 may be a single silicon oxide layer. Not only the first insulating layer 10, but also insulating layers of the circuit layer 120 to be described in more detail below, may be inorganic layers and/or organic layers, and may have a single-layer structure or a multi-layered structure. The inorganic layers may include at least one of the aforementioned inorganic materials, but the present disclosure is not limited thereto.

A gate GT of the transistor 100PC is disposed on the first insulating layer 10. The gate GT may be a portion of a metal pattern. The gate GT overlaps with the active area AL. The gate GT may function as a mask in a process of doping or reducing the semiconductor pattern SC, AL, DR, and SCL.

A second insulating layer 20 may be disposed on the first insulating layer 10, and may cover the gate GT. The second insulating layer 20 may commonly overlap with the pixels. The second insulating layer 20 may be an inorganic layer and/or an organic layer, and may have a single-layer structure or a multi-layered structure. The second insulating layer 20 may include at least one of silicon oxide, silicon nitride, and/or silicon oxy nitride. In the present embodiment, the second insulating layer 20 may have a multi-layered structure including a silicon oxide layer and a silicon nitride layer.

A third insulating layer 30 may be disposed on the second insulting layer 20. The third insulating layer 30 may have a single-layer structure or a multi-layered structure. For example, the third insulating layer 30 may have a multi-layered structure including a silicon oxide layer and a silicon nitride layer.

A first connecting electrode CNE1 may be disposed on the third insulating layer 30. The first connecting electrode CNE1 may be connected to the connecting signal line SCL through a contact hole CNT-1 that penetrates the first insulating layer 10, the second insulating layer 20, and the third insulating layer 30.

A fourth insulating layer 40 may be disposed on the third insulting layer 30. The fourth insulating layer 40 may be a single silicon oxide layer. A fifth insulating layer 50 may be disposed on the fourth insulting layer 40. The fifth insulating layer 50 may be an organic layer.

A second connecting electrode CNE2 may be disposed on the fifth insulating layer 50. The second connecting electrode CNE2 may be connected to the first connecting electrode CNE1 through a contact hole CNT-2 that penetrates the fourth insulating layer 40 and the fifth insulating layer 50.

A sixth insulating layer 60 may be disposed on the fifth insulating layer 50, and may cover the second connecting electrode CNE2. The sixth insulating layer 60 may be an organic layer.

The light emitting element layer 130 may be disposed on the circuit layer 120. The light emitting element layer 130 may include the light emitting element 100PE. For example, the light emitting element layer 130 may include an organic luminescent material, an inorganic luminescent material, an organic-inorganic luminescent material, a quantum dot, a quantum rod, a micro LED, or a nano-LED. Hereinafter, for convenience of illustration, the light emitting element 100PE may be described in more detail in the context of an organic light emitting element. However, the present disclosure is not particularly limited thereto.

The light emitting element 100PE may include a first electrode AE, an emissive layer EL, and a second electrode CE. The light emitting element 100PE may be disposed in the display area 100A (e.g., refer to FIG. 5). The first electrode AE may be referred to as a pixel electrode, and the second electrode CE may be referred to as a common electrode.

The first electrode AE may be disposed on the sixth insulting layer 60. The first electrode AE may be connected to the second connecting electrode CNE2 through a contact hole CNT-3 that penetrates the sixth insulating layer 60.

A pixel defining layer 70 may be disposed on the sixth insulating layer 60, and may cover a portion of the first electrode AE. An opening 70-OP is defined in the pixel defining layer 70. The opening 70-OP of the pixel defining layer 70 exposes at least a portion of the first electrode AE.

The display area 100A (e.g., refer to FIG. 5) may include an emissive area PXA, and a non-emissive area NPXA adjacent to the emissive area PXA. The non-emissive area NPXA may surround (e.g., around a periphery of) the emissive area PXA. In the present embodiment, the emissive area PXA is defined to correspond to a partial area of the first electrode AE exposed by the opening 70-OP.

The emissive layer EL may be disposed on the first electrode AE. The emissive layer EL may be disposed in an area corresponding to the opening 70-OP. Although FIG. 7A illustrates an example in which the emissive layer EL is disposed in the opening 70-OP, the present disclosure is not particularly limited thereto. For example, the emissive layer EL may extend to cover a side surface of the pixel defining layer 70 that defines the opening 70-OP, and a portion of the upper surface of the pixel defining layer 70.

In an embodiment of the present disclosure, the emissive layer EL may be separately included in each of the pixels. When the emissive layer EL is separately formed in each of the pixels, each of the emissive layers EL may emit at least one of a blue light, a red light, and/or a green light. However, the present disclosure is not limited thereto, and the emissive layer EL may have a one-body shape to be commonly included in the plurality of pixels. In this case, the emissive layer EL may provide a blue light or a white light.

The second electrode CE may be disposed on the emissive layer EL. The second electrode CE may have a one-body shape, and may be commonly included in the plurality of pixels.

In an embodiment of the present disclosure, a hole control layer may be disposed between the first electrode AE and the emissive layer EL. The hole control layer may be commonly disposed in the emissive area PXA and the non-emissive area NPXA. The hole control layer may include a hole transport layer, and may further include a hole injection layer as needed or desired. An electron control layer may be disposed between the emissive layer EL and the second electrode CE. The electron control layer may include an electron transport layer, and may further include an electron injection layer as needed or desired. The hole control layer and the electron control layer may be commonly formed in the plurality of pixels using an open mask or an ink-jet process.

The encapsulation layer 140 may be disposed on the light emitting element layer 130. The encapsulation layer 140 may include an inorganic layer, an organic layer, and an inorganic layer sequentially stacked one above another. However, the layers constituting the encapsulation layer 140 are not limited thereto. The inorganic layers may protect the light emitting element layer 130 from moisture and oxygen, and the organic layer may protect the light emitting element layer 130 from foreign matter, such as dust particles. The inorganic layers may include a silicon nitride layer, a silicon oxy nitride layer, a silicon oxide layer, a titanium oxide layer, or an aluminum oxide layer. The organic layer may include an acrylic organic layer, but the present disclosure is not limited thereto.

The sensor layer 200 may include a base layer 201, a first conductive layer 202, an intermediate insulating layer 203, a second conductive layer 204, and a cover insulating layer 205.

The base layer 201 may be an inorganic layer including at least one of silicon nitride, silicon oxy nitride, and/or silicon oxide. As another example, the base layer 201 may be an organic layer including an epoxy-based resin, an acrylic-based resin, or an imide-based resin. The base layer 201 may have a single-layer structure, or may have a multi-layered structure stacked in the third direction DR3. In an embodiment of the present disclosure, the sensor layer 200 may not include the base layer 201.

Each of the first conductive layer 202 and the second conductive layer 204 may have a single-layer structure, or may have a multi-layered structure stacked in the third direction DR3.

Each of the first conductive layer 202 and the second conductive layer 204 that have a single-layer structure may include a metal layer or a transparent conductive layer. The metal layer may include molybdenum, silver, titanium, copper, aluminum, or a suitable alloy thereof. The transparent conductive layer may include a transparent conductive oxide, such as indium tin oxide (ITO), indium zinc oxide (IZO), zinc oxide (ZnO), or indium zinc tin oxide (IZTO). In addition, the transparent conductive layer may include a conductive polymer, such as poly(3,4-ethylenedioxythiophene)(PEDOT), a metal nano wire, or graphene.

Each of the first conductive layer 202 and the second conductive layer 204 that have a multi-layered structure may include a plurality of metal layers. The metal layers may have, for example, a three-layered structure of titanium/aluminum/titanium. The conductive layer having the multi-layered structure may include at least one metal layer and at least one transparent conductive layer.

In an embodiment of the present disclosure, the thickness of the first conductive layer 202 may be greater than or equal to the thickness of the second conductive layer 204. When the thickness of the first conductive layer 202 is greater than the thickness of the second conductive layer 204, a resistance of a component (e.g., an electrode, a pattern, or a bridge pattern) included in the first conductive layer 202 may be reduced. In addition, because the first conductive layer 202 may be disposed under the second conductive layer 204, a probability that the components included in the first conductive layer 202 will be visually recognized due to an external light reflection may be lower than that of the second conductive layer 204, even though the thickness of the first conductive layer 202 is increased.

At least one of the intermediate insulating layer 203 and/or the cover insulating layer 205 may include an inorganic film. The inorganic film may include at least one of aluminum oxide, titanium oxide, silicon oxide, silicon nitride, silicon oxy nitride, zirconium oxide, and/or hafnium oxide.

At least one of the intermediate insulating layer 203 and/or the cover insulating layer 205 may include an organic film. The organic film may include at least one of an acrylic-based resin, a methacrylic-based resin, a polyisoprene-based resin, a vinyl-based resin, an epoxy-based resin, a urethane-based resin, a celluosic-based resin, a siloxane-based resin, a polyimide-based resin, a polyamide-based resin, and/or a perylene-based resin.

Although it has been described that the sensor layer 200 includes the first conductive layer 202 and the second conductive layer 204, or in other words, a total of two conductive layers, the present disclosure is not particularly limited thereto. For example, the sensor layer 200 may include three or more conductive layers.

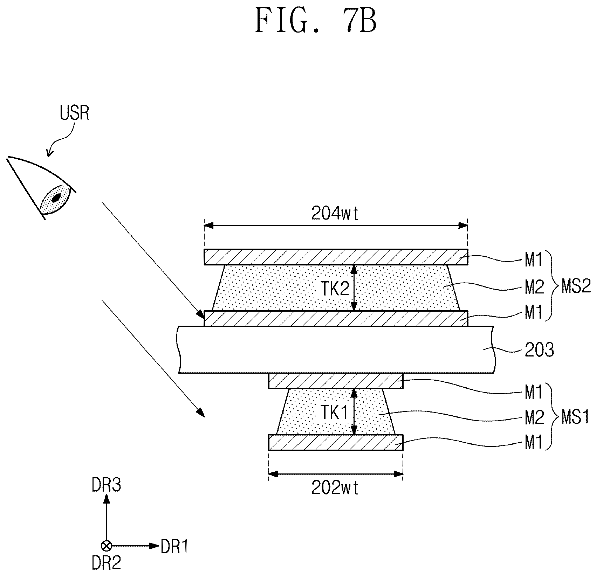

FIG. 7B is a sectional view illustrating some components of the sensor layer 200 according to an embodiment of the present disclosure.

Referring to FIGS. 7A and 7B, a second width 204wt of a second mesh line MS2 included in the second conductive layer 204 may be greater than or equal to a first width 202wt of a first mesh line MS1 included in the first conductive layer 202. When a user USR views the first mesh line MS1 and the second mesh line MS2 from the side, a probability that the first mesh line MS1 will be visually recognized by the user USR may be reduced, because the first mesh line MS1 has the smaller first width 202wt than the second width 204wt of the second mesh line MS2.

Each of the first mesh line MS1 and the second mesh line MS2 may include first metal layers M1, and a second metal layer M2 disposed between the first metal layers M1. For example, the first metal layers M1 may include titanium (Ti), and the second metal layer M2 may include aluminum (Al). However, the present disclosure is not particularly limited thereto.

In an embodiment of the present disclosure, a first thickness TK1 of the second metal layer M2 of the first mesh line MS1 and a second thickness TK2 of the second metal layer M2 of the second mesh line MS2 may be the same or substantially the same as each other, but the present disclosure is not particularly limited thereto. For example, the first thickness TK1 may be greater than the second thickness TK2. As another example, the second thickness TK2 may be greater than the first thickness TK1. In an embodiment of the present disclosure, each of the first thickness TK1 and the second thickness TK2 may be 1000Å or more, for example, such as 6000Å.

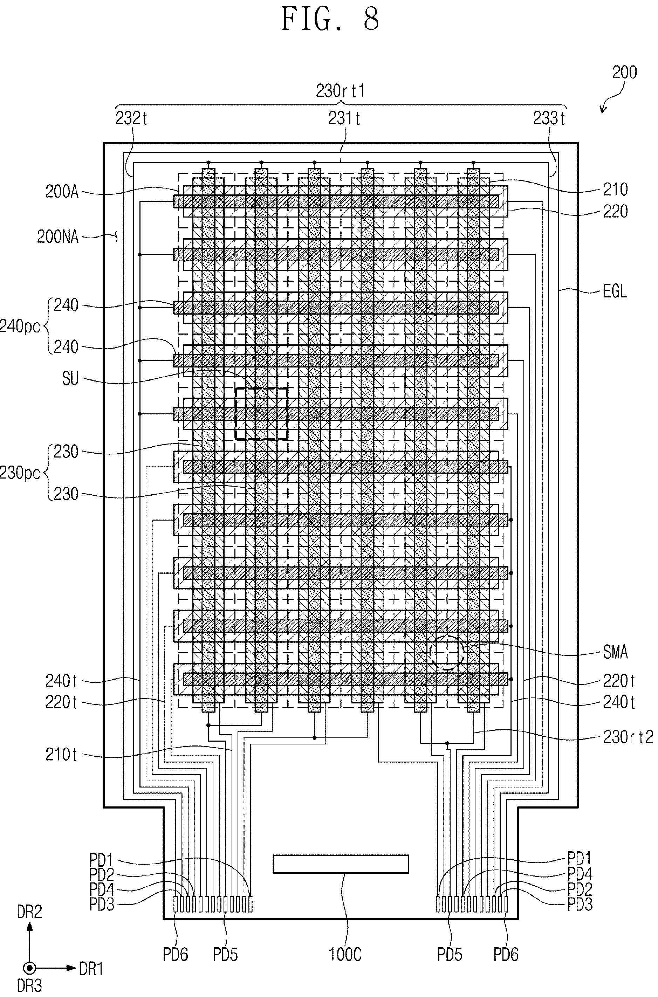

FIG. 8 is a plan view of the sensor layer 200 according to an embodiment of the present disclosure.

Referring to FIG. 8, the sensing area 200A and the peripheral area 200NA adjacent to the sensing area 200A may be defined in the sensor layer 200.

The sensor layer 200 may include a plurality of first electrodes 210, a plurality of second electrodes 220, a plurality of third electrodes 230, and a plurality of fourth electrodes 240 disposed in the sensing area 200A.

Each of the first electrodes 210 may cross the second electrodes 220. Each of the first electrodes 210 may extend in the second direction DR2, and the first electrodes 210 may be spaced apart from one another along the first direction DR1. Each of the second electrodes 220 may extend in the first direction DR1, and the second electrodes 220 may be spaced apart from one another along the second direction DR2. A sensing unit SU of the sensor layer 200 may be an area where one first electrode 210 and one second electrode 220 cross each other.

In FIG. 8, six first electrodes 210 and ten second electrodes 220 are illustrated as an example, and 60 sensing units SU are illustrated as an example. However, the number of first electrodes 210 and the number of second electrodes 220 are not limited thereto.

Each of the third electrodes 230 may extend in the second direction DR2, and the third electrodes 230 may be spaced apart from one another along the first direction DR1. One third electrode 230 may at least partially overlap with one first electrode 210. According to an embodiment of the present disclosure, a capacitance (e.g., a coupling capacitance) between one first electrode 210 and one third electrode 230 may be adjusted by adjusting the overlapping area between the one first electrode 210 and the one third electrode 230.

In an embodiment of the present disclosure, at least some of the third electrodes 230 may be connected in parallel with each other. For example, FIG. 8 illustrates an example in which two third electrodes 230 are connected in parallel with each other to constitute a first electrode group 230pc, and three first electrode groups 230pc may be arranged along the first direction DR1. However, the number of third electrodes 230 constituting the first electrode group 230pc is not limited thereto. For example, one first electrode group 230pc may include only one third electrode 230, or may include three or more third electrodes 230.

As the number of third electrodes 230 included in the first electrode group 230pc and connected in parallel with each other is increased, a resistance of the first electrode group 230pc may be lowered, and thus, a power efficiency and a sensing sensitivity may be improved. On the other hand, as the number of third electrodes 230 included in the first electrode group 230pc is decreased, a loop coil pattern formed using the first electrode group 230pc may be implemented in more diverse forms.

The fourth electrodes 240 may be arranged along the second direction DR2, and may extend in the first direction DR1. One fourth electrode 240 may at least partially overlap with one second electrode 220. According to an embodiment of the present disclosure, a capacitance (e.g., a coupling capacitance) between one second electrode 220 and one fourth electrode 240 may be adjusted by adjusting the overlapping area between the one second electrode 220 and the one fourth electrode 240.

In an embodiment of the present disclosure, at least some of the fourth electrodes 240 may be electrically connected to each other to constitute one second electrode group 240pc. For example, FIG. 8 illustrates an example in which five fourth electrodes 240 are connected to the same one trace line, for example, such as an auxiliary trace line 240t, to constitute one second electrode group 240pc. Accordingly, in FIG. 8, two second electrode groups 240pc are illustrated as being arranged along the second direction DR2. However, the number of fourth electrodes 240 constituting one second electrode group 240pc is not limited thereto. For example, the number of fourth electrodes 240 constituting one second electrode group 240pc may be ten. In this case, the sensor layer 200 may include only one second electrode group 240pc.

The sensor layer 200 may further include a plurality of first trace lines 210t disposed in the peripheral area 200NA, a plurality of first pads PD1 connected to the first trace lines 210t in a one-to-one correspondence, a plurality of second trace lines 220t, and a plurality of second pads PD2 connected to the second trace lines 220t in a one-to-one correspondence. The first trace lines 210t may be electrically connected to the first electrodes 210 in a one-to-one correspondence. The second trace lines 220t may be electrically connected to the second electrodes 220 in a one-to-one correspondence.

The sensor layer 200 may further include a first loop trace line 230rt1 disposed in the peripheral area 200NA, a plurality of third pads PD3 connected to one end and an opposite end of the first loop trace line 230rt1, auxiliary trace lines 240t, fourth pads PD4 connected to the auxiliary trace lines 240t in a one-to-one correspondence, second loop trace lines 230rt2, and fifth pads PD5 connected to the second loop trace lines 230rt2 in a one-to-one correspondence. The first loop trace line 230rt1 may be referred to as a loop trace line, the second loop trace lines 230rt2 may be referred to as third trace lines, and the auxiliary trace lines 240t may be referred to as fourth trace lines.

In an embodiment of the present disclosure, the first loop trace line 230rt1 may be electrically connected with the third electrodes 230. In other words, the first loop trace line 230rt1 may be electrically connected with all of the third electrodes 230. The third electrodes 230 may be referred to as charging electrodes.

The first loop trace line 230rt1 may include a first line portion 231t that extends in the first direction DR1 and is electrically connected to the third electrodes 230, a second line portion 232t that extends from a first end of the first line portion 231t in the second direction DR2, and a third line portion 233t that extends from a second end of the first line portion 231t in the second direction DR2.

The first line portion 231t may be spaced apart from the first to fifth pads PD1, PD2, PD3, PD4, and PD5 disposed in the peripheral area 200NA with the sensing area 200A therebetween. Some of the second trace lines 220t may be disposed between the second line portion 232t and the first electrodes 210, and other second trace lines 220t may be disposed between the third line portion 233t and the first electrodes 210.

Each of the second line portion 232t and the third line portion 233t may extend in the same direction as the extension direction of the third electrodes 230, for example, such as in the second direction DR2. Each of the second line portion 232t and the third line portion 233t may serve as the first electrode group 230pc, and there may be obtained the same effect as placing the third electrodes 230 in the peripheral area 200NA. For example, one of the second line portion 232t or the third line portion 233t and one of the third electrodes 230 may form a coil. Accordingly, a pen located in an area adjacent to the peripheral area 200NA may be sufficiently charged by a loop (or a current path) including the second line portion 232t or the third line portion 233t.

In an embodiment of the present disclosure, the positions of the second line portion 232t and the third line portion 233t and the widths thereof in the first direction DR1 may be adjusted to adjust a resistance of the second line portion 232t and a resistance of the third line portion 233t. In this case, the pen may be sufficiently charged through a current path including the second line portion 232t or the third line portion 233t. As a result, a pen charging performance of the electronic device 1000 (e.g., refer to FIG. 2A) may be improved. In other words, as a charging rate of the pen is improved, a signal-to-noise ratio of a signal provided from the pen may be increased. Accordingly, a linearity and an accuracy of a pen input may be improved.

The second loop trace lines 230rt2 may be connected to the first electrode groups 230pc in a one-to-one correspondence. In other words, the number of second loop trace lines 230rt2 may correspond to the number of first electrode groups 230pc. In FIG. 8, three second loop trace lines 230rt2 and three first electrode groups 230pc are illustrated as an example.

The auxiliary trace lines 240t may be spaced apart from each other with the sensing area 200A therebetween. The auxiliary trace lines 240t may be electrically connected to the second electrode groups 240pc in a one-to-one correspondence. FIG. 8 illustrates an example in which two second electrode groups 240pc are arranged. An auxiliary trace line 240t connected to one second electrode group 240pc and an auxiliary trace line 240t connected to another second electrode group 240pc may be spaced apart from each other with the sensing area 200A therebetween. However, the present disclosure is not particularly limited thereto. The auxiliary trace lines 240t may be referred to as trace lines.

In an embodiment of the present disclosure, the sensor layer 200 may further include a shielding line EGL disposed in the peripheral area 200NA, and sixth pads PD6 connected to the shielding line EGL. The shielding line EGL may be disposed adjacent to the outermost edge of the sensor layer 200. The shielding line EGL may be referred to as an electrostatic shielding line or a ground line, and the sixth pads PD6 may be referred to as ground pads. The shielding line EGL may be grounded, or a constant voltage may be provided to the shielding line EGL.

In an embodiment of the present disclosure, the sensing area 200A of the sensor layer 200 may include the second area SMA. The second area SMA may be an area having a relatively higher transmittance in the sensing area 200A. For example, each of the first to fourth electrodes 210, 220, 230, and 240 may have a mesh structure. Each of the first to fourth electrodes 210, 220, 230, and 240 may have a relatively low-density mesh structure in the second area SMA. This will be described in more detail below.

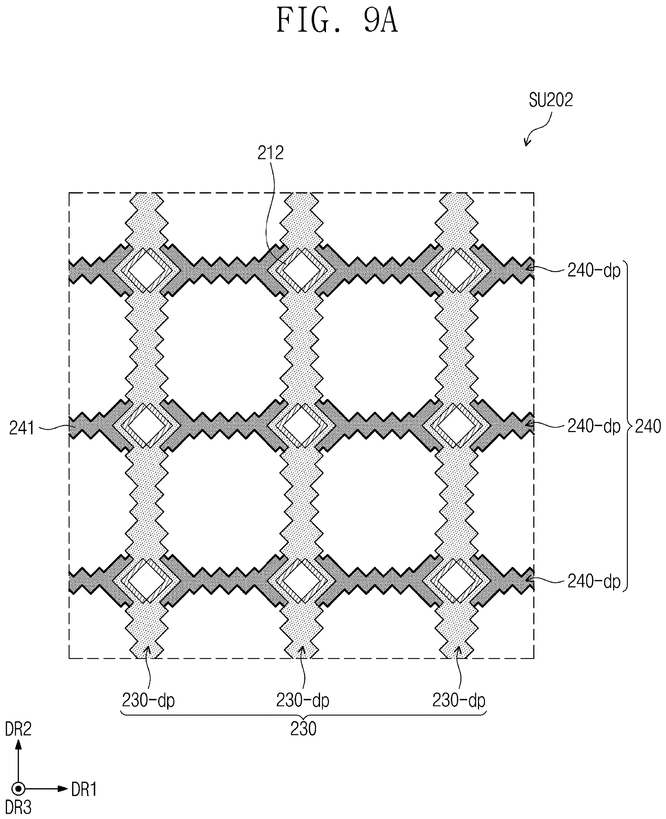

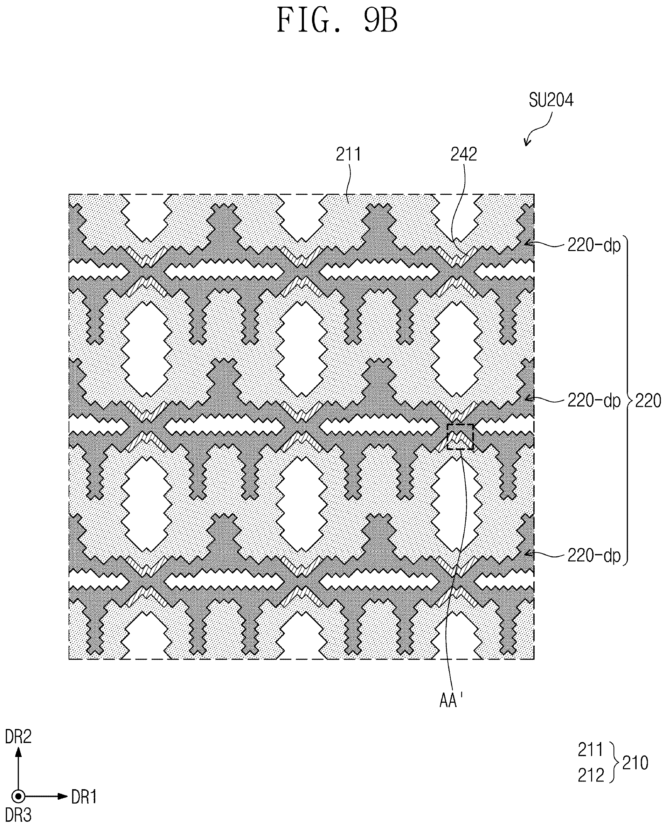

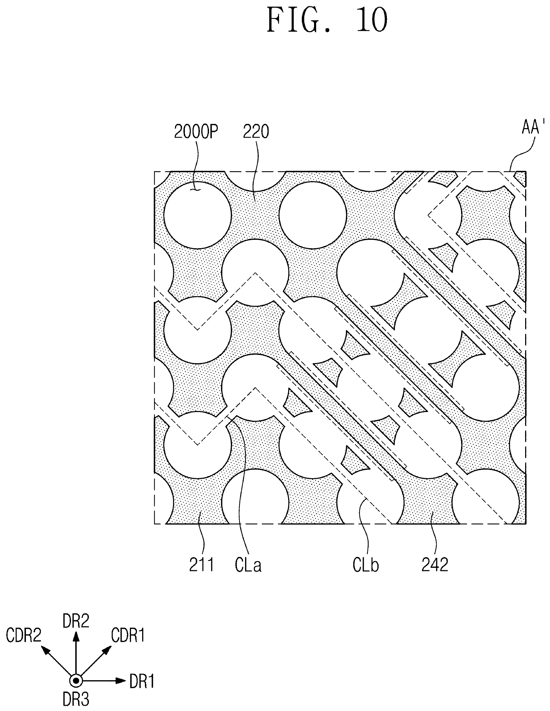

FIG. 9A is a plan view illustrating a first conductive layer SU202 of a sensing unit SU according to an embodiment of the present disclosure. FIG. 9B is a plan view illustrating a second conductive layer SU204 of the sensing unit SU according to an embodiment of the present disclosure. FIG. 10 is an enlarged plan view of the area AA' illustrated in FIG. 9B.

In FIGS. 9A and 9B, the shape of a mesh structure is not illustrated, and boundaries between components are briefly illustrated by lines. In other words, the lines illustrated in FIGS. 9A and 9B may be understood as corresponding to the lines where the mesh structure illustrated in FIG. 10 is removed, and in FIG. 10, lines CLa, and CLb are illustrated by dotted lines.

The shape of the sensing unit SU and the mesh structure illustrated in FIGS. 9A, 9B, and 10 are merely illustrative, and the present disclosure is not limited thereto. The shape of the sensing unit SU and the mesh structure may be variously modified as needed or desired.

Referring to FIGS. 9A and 9B, the first electrode 210 may include a plurality of first patterns 211, and a plurality of first bridge patterns 212 electrically connected to the first patterns 211. The first patterns 211 may be spaced apart from one another in the second direction DR2, and may be electrically connected to each other by the first bridge patterns 212. The first patterns 211 may be included in the second conductive layer SU204, and the first bridge patterns 212 may be included in the first conductive layer SU202.

Two first patterns 211 that are adjacent to each other in the second direction DR2 in one first electrode 210 may be electrically connected with each other by six first bridge patterns 212. An increase in the number of first bridge patterns 212 arranged in the first direction DR1 crossing the second direction DR2 that is the extension direction of the first electrode 210 may correspond to an increase in the number of signal paths. Accordingly, as the number of signal paths is increased, a resistance of the first electrode 210 may be reduced. As a result, the sensing sensitivity of the sensor layer 200 may be improved.

The second electrode 220 may include a plurality of first divided electrodes 220-dp spaced apart from one another in the second direction DR2. Each of the first divided electrodes 220-dp may extend in the first direction DR1, and the first divided electrodes 220-dp may be spaced apart from one another in the second direction DR2. The first divided electrodes 220-dp may be included in the second conductive layer SU204. Three first divided electrodes 220-dp included in one second electrode 220 may be connected to one second trace line 220t (e.g., refer to FIG. 8).

The third electrode 230 may include a plurality of second divided electrodes 230-dp spaced apart from one another in the first direction DR1. Each of the second divided electrodes 230-dp may extend in the second direction DR2. The second divided electrodes 230-dp may be spaced apart from one another in the first direction DR1. The second divided electrodes 230-dp may at least partially overlap with the first patterns 211 when viewed in the third direction DR3 (e.g., in a plan view).

Referring to FIGS. 8 and 9A together, one second loop trace line 230rt2 is electrically connected to one first electrode group 230pc. The one first electrode group 230pc may include two third electrodes 230. In this case, the one second loop trace line 230rt2 may be electrically connected to six second divided electrodes 230-dp. In this case, a degree to which the number of pads in the sensor layer 200 is increased may be reduced.

The fourth electrode 240 may include a plurality of third divided electrodes 240-dp spaced apart from one another in the second direction DR2. Each of the third divided electrodes 240-dp may extend in the first direction DR1. Each of the third divided electrodes 240-dp may include a plurality of second patterns 241, and a plurality of second bridge patterns 242 electrically connected to the second patterns 241. The second patterns 241 and the second bridge patterns 242 may be electrically connected with each other through contact holes defined in the first intermediate layer 203 (e.g., refer to FIG. 7A). Two second patterns 241 that are adjacent to each other may be spaced apart from each other with one second divided electrode 230-dp and two first bridge patterns 212 therebetween.

Although FIGS. 9A and 9B illustrate an example in which three first divided electrodes 220-dp, three second divided electrodes 230-dp, and three third divided electrodes 240-dp are included in one sensing unit SU, the present disclosure is not particularly limited thereto. For example, the numbers of first divided electrodes 220-dp, second divided electrodes 230-dp, and third divided electrodes 240-dp included in one sensing unit SU may be one, two, or four or more.

In an embodiment of the present disclosure, a first capacitor may be defined between the first electrode 210 and the third electrode 230, and a second capacitor may be defined between the second electrode 220 and the fourth electrode 240. A first capacitance of the first capacitor and a second capacitance of the second capacitor may be adjusted by adjusting the overlapping area between the first electrode 210 and the third electrode 230 and the overlapping area between the second electrode 220 and the fourth electrode 240, respectively.

As the first capacitance and the second capacitance are increased, an amount of an induced current transferred from the third electrode 230 to the first electrode 210 may be increased, and an amount of an induced current transferred from the fourth electrode 240 to the second electrode 220 may be increased. Accordingly, a pen sensing performance of the sensor layer 200 may be improved as the first capacitance and the second capacitance are increased. In addition, the first capacitor and the second capacitor may act as loads during a touch sensing. Accordingly, a touch sensing performance may be improved as the first capacitance and the second capacitance are decreased.

In an embodiment of the present disclosure, the overlapping area between the first electrode 210 and the third electrode 230 and the overlapping area between the second electrode 220 and the fourth electrode 240 may be easily adjusted. Accordingly, the sensor layer 200 having appropriate levels of capacitances considering a touch sensitivity and a pen sensing sensitivity may be provided. As a result, the electronic device 1000 (e.g., refer to FIG. 2A) having an improved pen sensing sensitivity and touch sensitivity may be provided.

In an embodiment of the present disclosure, in the second conductive layer SU204 within one sensing unit SU, an area occupied by the components included in the first electrode 210 and the second electrode 220 may be greater than an area occupied by the components included in the third electrode 230 and the fourth electrode 240. A change in capacitance due to the first input 2000 (e.g., refer to FIG. 6) may be increased as a distance is decreased. Accordingly, a component for sensing the first input 2000 (e.g., refer to FIG. 6) may be disposed in a larger area in a layer relatively more adjacent to the surface of the electronic device 1000 (e.g., refer to FIG. 1). As a result, a touch performance may be improved.

Referring to FIGS. 9A, 9B, and 10, each of the first to fourth electrodes 210, 220, 230, and 240 may have a mesh structure. The mesh structure may be a structure in which a plurality of openings 200OP are defined. Although FIG. 10 illustrates an example in which each of the plurality of openings 200OP has a circular shape with a suitable curvature (e.g., a certain or predetermined curvature), the present disclosure is not particularly limited thereto. For example, each of the openings 200OP may be modified to have various suitable shapes, such as a quadrangular shape, a polygonal shape, or an irregular shape.

In FIG. 10, portions of the first pattern 211, the second bridge pattern 242, and the second electrode 220 disposed in the second conductive layer SU204 are illustrated. The first pattern 211, the second bridge pattern 242, and the second electrode 220 may be electrically insulated from one another. For example, the first pattern 211, the second bridge pattern 242, and the second electrode 220 may be electrically insulated from one another by first lines CLa extending in a first crossing direction CDR1 that crosses the first direction DR1 and the second direction DR2, and second lines CLb extending in a second crossing direction CDR2 crossing the first crossing direction CDR1. A portion and another portion of the conductive layer may be spaced apart from each other with the first lines CLa and the second lines CLb therebetween.

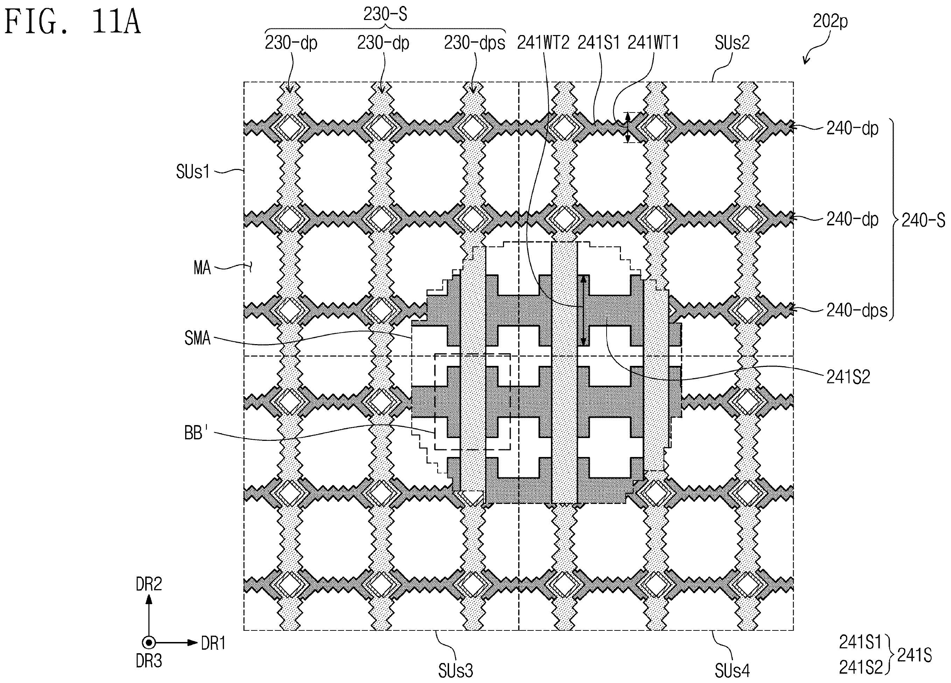

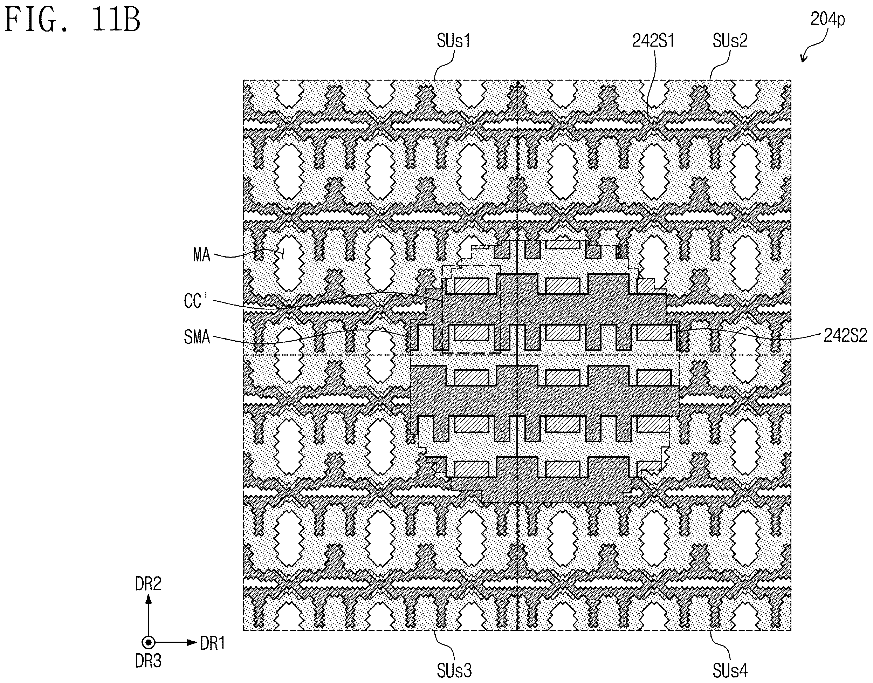

FIG. 11A is a plan view illustrating a portion of a first conductive layer 202p of a sensor layer 200 according to an embodiment of the present disclosure. FIG. 11B is a plan view illustrating a portion of a second conductive layer 204p of the sensor layer 200 according to an embodiment of the present disclosure. The first conductive layer 202p may be included in the first conductive layer 202 described above with reference to FIG. 7A, and the second conductive layer 204p may be included in the second conductive layer 204 described above with reference to FIG. 7A.

Referring to FIGS. 8, 11A, and 11B, four sensing units SUs1, SUs2, SUs3, and SUs4 overlapping with the second area SMA are illustrated as an example. In the second area SMA, a third electrode 230-S overlapping with the second area SMA among the third electrodes 230 may be insulated from a fourth electrode 240-s overlapping with the second area SMA among the fourth electrodes 240, and may cross the fourth electrode 240-S.

According to an embodiment of the present disclosure, the third electrode 230-S may include second divided electrodes 230-dp and 230-dps spaced apart from one another in the first direction DR1, and the fourth electrode 240-S may include third divided electrodes 240-dp and 240-dps spaced apart from one another in the second direction DR2. The second divided electrode 230-dps overlapping with the second area SMA among the second divided electrodes 230-dp and 230-dps and the third divided electrode 240-dps overlapping with the second area SMA among the third divided electrodes 240-dp and 240-dps may be insulated from each other, and may cross each other.

FIGS. 11A and 11B illustrate an example in which in the second area SMA, three second divided electrodes 230-dps and three third divided electrodes 240-dps are insulated from each other and cross each other. For example, the numbers of second divided electrodes and third divided electrodes that are insulated from each other and cross each other in the second area SMA may be variously modified depending on the size, the formation, or the position of the second area SMA.

According to an embodiment of the present disclosure, a portion and another portion of the third electrode 230-S that are spaced apart from each other with the second area SMA therebetween may not be electrically isolated from each other, even though the second area SMA is provided in the sensor layer 200 to overlap with the sensing area 200A. In addition, a portion and another portion of the fourth electrode 240-S that are spaced apart from each other with the second area SMA therebetween may not be electrically isolated from each other. Accordingly, even though the sensing area 200A overlaps with the second area SMA, a portion of each of the first to fourth electrodes 210, 220, 230, and 240 may not be dummy patterned. As a result, a sensitivity of the sensor layer 200 may be improved.

According to an embodiment of the present disclosure, the fourth electrode 240-S may include a plurality of patterns 241S that are spaced apart from one another in the first direction DR1, a first-type bridge pattern 242S1 connected to two adjacent patterns 241S1 among the plurality of patterns 241S, and a second-type bridge pattern 242S2 connected to two other adjacent patterns 241S2 among the plurality of patterns 241S.

In an embodiment of the present disclosure, the first-type bridge pattern 242S1 may overlap with the first area MA, and the second-type bridge pattern 242S2 may overlap with the second area SMA. The shape of the first-type bridge pattern 242S1 and the shape of the second-type bridge pattern 242S2 may be different from each other.

In an embodiment of the present disclosure, the shape of the two patterns 241S1 may be different from the shape of the two other patterns 241S2. For example, a maximum width 241WT1 of one pattern 241S1 connected to the first-type bridge pattern 242S1 in the second direction DR2 may be smaller than a maximum width 241WT2 of one pattern 241S2 connected to the second-type bridge pattern 242S2 in the second direction DR2.

In an embodiment of the present disclosure, the first to fourth electrodes 210, 220, 230, and 240 in the sensor layer 200 may have a mesh structure. The first to fourth electrodes 210, 220, 230, and 240 may have a first mesh structure in the first area MA, and may have a second mesh structure in the second area SMA. For example, a density of the first mesh structure may be higher than a density of the second mesh structure. Accordingly, a resistance difference that may be caused by the difference between the mesh structures may be compensated for by making a difference between the shape of a pattern overlapping with the first area MA and the shape of a pattern overlapping with the second area SMA. For example, the resistance increased by the mesh structure having a lower density may be decreased again by an increase in the size of the pattern.

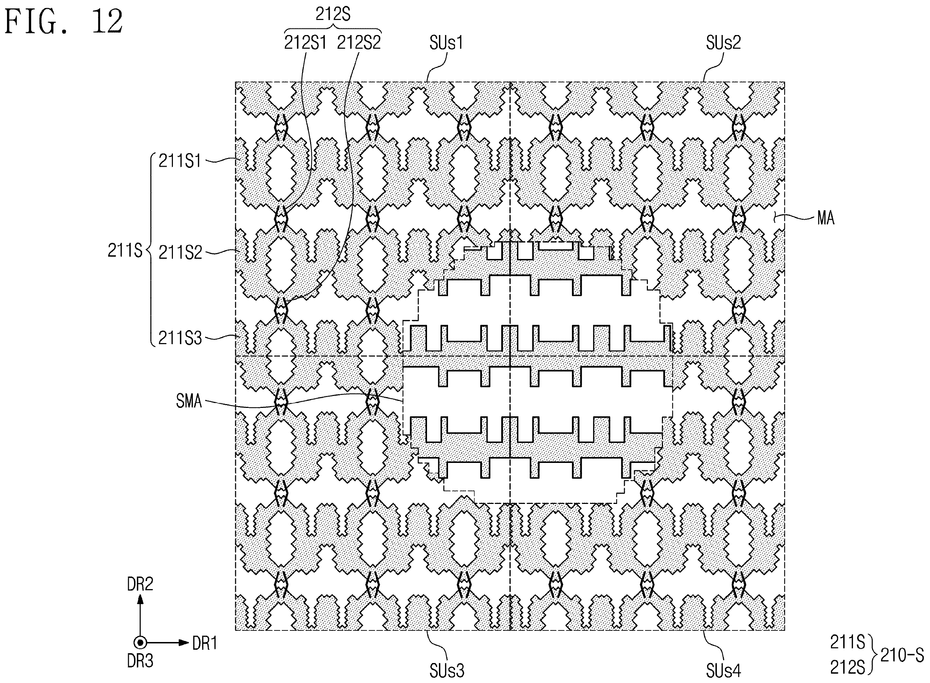

FIG. 12 is a plan view illustrating some components of the sensor layer 200 according to an embodiment of the present disclosure.

Referring to FIG. 12, two first electrodes 210-S overlapping with the second area SMA are illustrated as an example. One first electrode 210-S may overlap with two sensing units SUs1 and SUs3, and another first electrode 210-S may overlap with two sensing units SUs2 and SUs4.

Each of the first electrodes 210-S may include a plurality of sensing patterns 211S that are spaced apart from one another in the second direction DR2, and a plurality of bridge patterns 212S electrically connected to the plurality of sensing patterns 211S. The bridge patterns 212S may not overlap with the second area SMA.

In an embodiment of the present disclosure, the sensing patterns 211S of the first electrode 210-S may include a first sensing pattern 211S1, a second sensing pattern 211S2, and a third sensing pattern 211S3 spaced apart from one another in the second direction DR2. In addition, the bridge patterns 212S of the first electrode 210-S may include a plurality of first bridge patterns 212S1 connected to the first sensing pattern 211S1 and the second sensing pattern 211S2 and arranged in the first direction DR1, and a plurality of second bridge patterns 212S2 connected to the second sensing pattern 211S2 and the third sensing pattern 211S3 and arranged in the first direction DR1.

At least a portion of each of the second sensing pattern 211S2 and the third sensing pattern 211S3 may overlap with the second area SMA. The first bridge patterns 212S1 and the second bridge patterns 212S2 may not overlap with the second area SMA. Accordingly, the number of first bridge patterns 212S1 may be greater than the number of second bridge patterns 212S2. FIG. 12 illustrates an example in which the number of first bridge patterns 212S1 is six and the number of second bridge patterns 212S2 is four.

Even though the bridge patterns of the first electrode 210-S are omitted in an area overlapping with the second area SMA, the sensing patterns 211S included in the first electrode 210-S may be electrically connected to each other by the bridge patterns 212S overlapping with the first area MA.

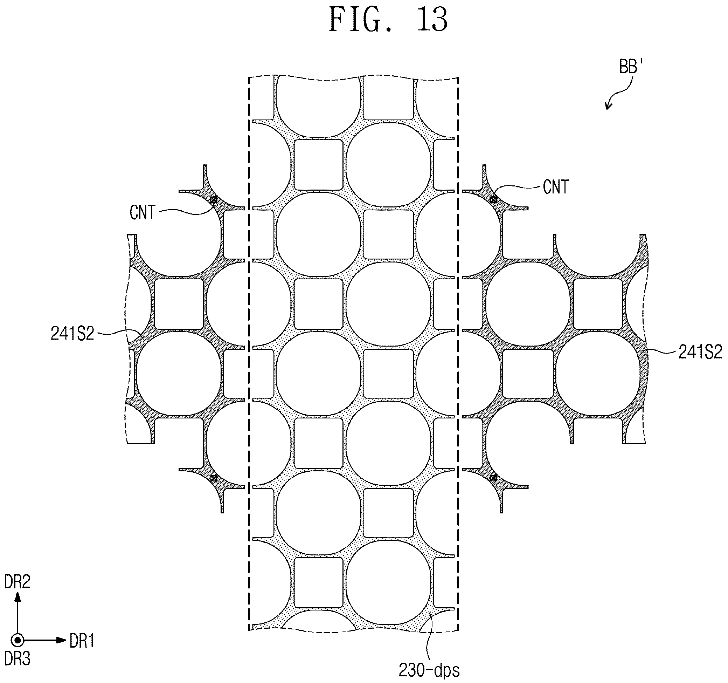

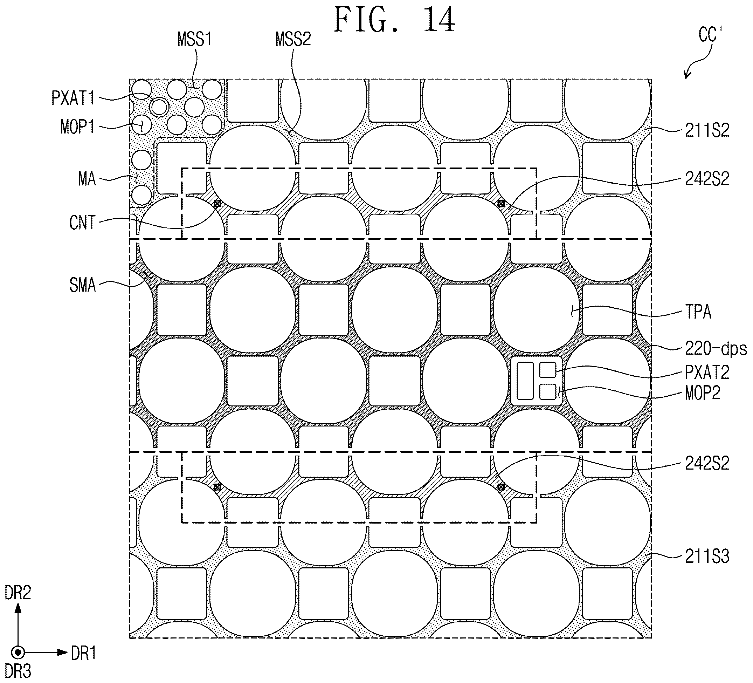

FIG. 13 is an enlarged plan view of the area BB' illustrated in FIG. 11A. FIG. 14 is an enlarged plan view of the area CC' illustrated in FIG. 11B.

Referring to FIGS. 8, 13, and 14, the first to fourth electrodes 210, 220, 230, and 240 in the sensor layer 200 may have a mesh structure. The first to fourth electrodes 210, 220, 230, and 240 may have a first mesh structure MSS1 in the first area MA, and may have a second mesh structure MSS2 in the second area SMA. For example, a density of the first mesh structure MSS1 may be higher than a density of the second mesh structure MSS2.

A plurality of emissive areas PXA (e.g., refer to FIG. 7A) may be defined in the display layer 100. In FIG. 14, one first-type emissive area PXAT1 among first-type emissive areas PXAT1 overlapping with the first area MA, and a plurality of second-type emissive areas PXAT2 overlapping with the second area SMA are illustrated as an example.

The first mesh structure MSS1 may include a first opening MOP1 overlapping with the first-type emissive area PXAT1. The second mesh structure MSS2 may include a second opening MOP2 overlapping with n second-type emissive areas (n being an integer of 1 or more) among the second-type emissive areas PXAT2. The first opening MOP1 and the second opening MOP2 may be provided in a plurality. FIG. 14 illustrates an example in which one first opening MOP1 overlaps with one first-type emissive area PXAT1, and one second opening MOP2 overlaps with three second-type emissive areas PXAT2. In addition, the second mesh structure MSS2 may further include a plurality of transmissive openings TPA. Accordingly, a transmittance of the second area SMA may be higher than a transmittance of the first area MA.

The size of the first opening MOP1 may be smaller than the size of the second opening MOP2. In addition, the transmissive openings TPA are additionally defined in the second mesh structure MSS2. Accordingly, a density of the first mesh structure MSS1 may be higher than a density of the second mesh structure MSS2.

Referring to FIG. 13, two patterns 241S2 and one second divided electrode 230-dps are illustrated as an example. The two patterns 241S2 may be spaced apart from each other with the one second divided electrode 230-dps therebetween.

Referring to FIG. 14, a second sensing pattern 211S2, a third sensing pattern 211S3, one divided electrode 220-dps included in a second electrode 220, and two second-type bridge patterns 242S2 are illustrated. The two second-type bridge patterns 242S2 may be spaced apart from each other with the divided electrode 220-dps therebetween.

The two second-type bridge patterns 242S2 may be connected to the two patterns 241S2 through contacts CNT, respectively. For example, the two second-type bridge patterns 242S2 may penetrate the intermediate insulating layer 203 (e.g., refer to FIG. 7A), and may be connected to the two patterns 241S2.

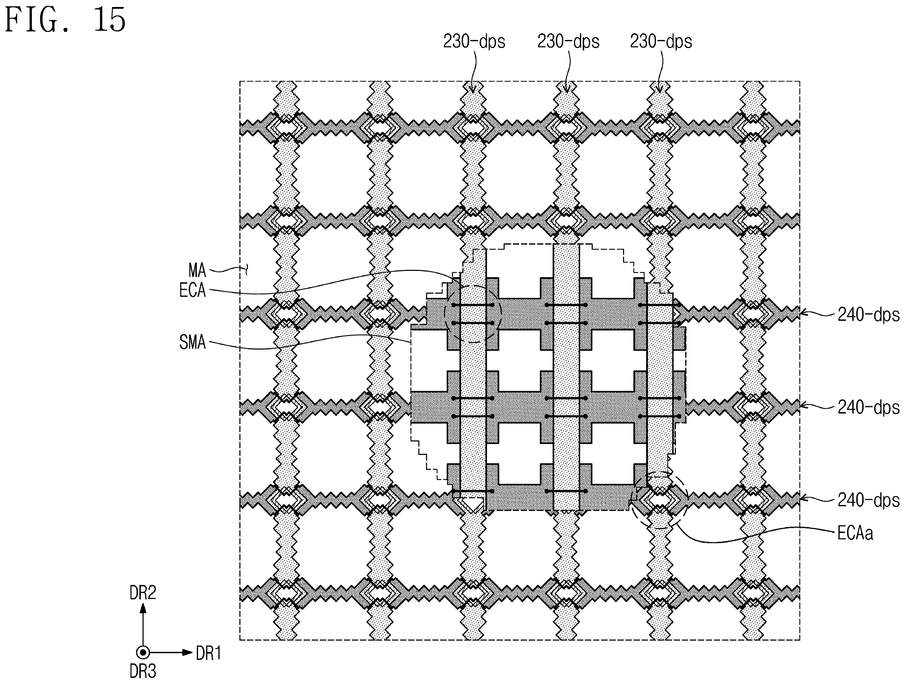

FIG. 15 is a plan view illustrating some components of the sensor layer 200 according to an embodiment of the present disclosure.

Referring to FIGS. 8 and 15, the third electrodes 230 may include X second divided electrodes 230-dps (hereinafter, referred to as the first divided electrodes) that are spaced apart from one another in the first direction DR1, where X may be an integer of 1 or more (e.g., an integer of 2 or more). The fourth electrodes 240 may include Y third divided electrodes 240-dps (hereinafter, referred to as the second divided electrodes) spaced apart from one another in the second direction DR2, where Y may be an integer of 2 or more.

According to an embodiment of the present disclosure, in X * Y intersection areas ECA and ECAa, the X first divided electrodes 230-dps and the Y second divided electrodes 240-dps may be insulated from each other and may cross each other.

In FIG. 15, three first divided electrodes 230-dps and three second divided electrodes 240-dps that overlap with the second area SMA are illustrated as an example. In nine intersection areas ECA and ECAa, the first divided electrodes 230-dps and the second divided electrodes 240-dps may be insulated from each other and may cross each other. Among the nine intersection areas ECA and ECAa, eight intersection areas ECA may overlap with the second area SMA, and one intersection area ECAa may overlap with the first area MA.

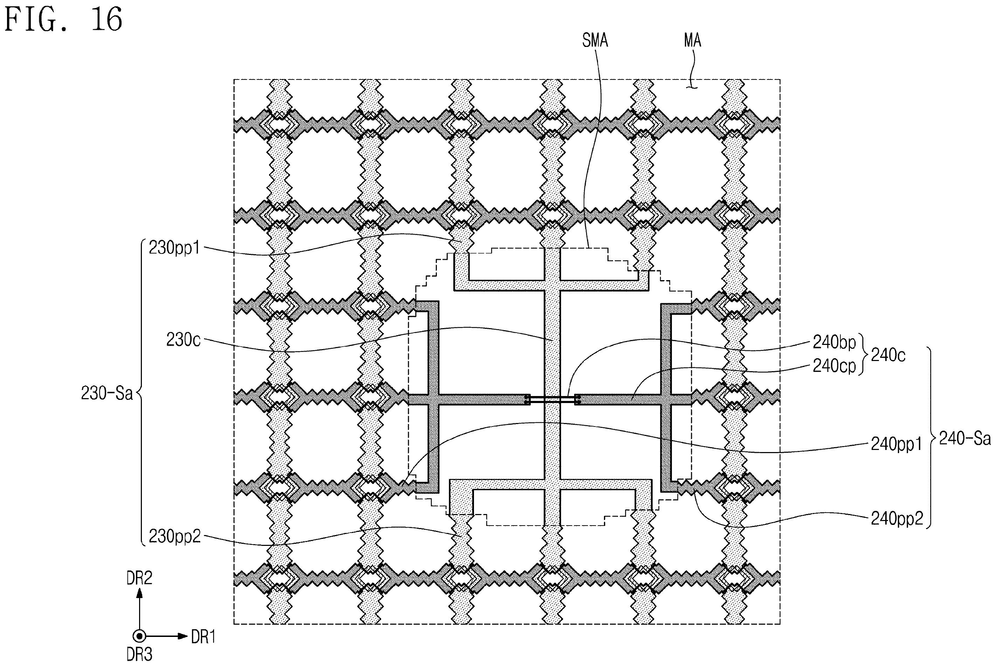

FIG. 16 is a plan view illustrating some components of a sensor layer 200 according to an embodiment of the present disclosure.

Referring to FIG. 16, a third electrode 230-Sa may include first divided electrode portions 230pp1 and 230pp2, and a first connecting electrode portion 230c that is connected to all of the first divided electrode portions 230pp1 and 230pp2 and that overlaps with the second area SMA.

The first divided electrode portions 230pp1 and the first divided electrode portions 230pp2 may be spaced apart from each other with the second area SMA therebetween. The first divided electrode portions 230pp1 may be spaced apart from one another in the first direction DR1, and the first divided electrode portions 230pp2 may be spaced apart from one another in the first direction DR1.

A fourth electrode 240-Sa may include a plurality of second divided electrode portions 240pp1 and 240pp2 spaced apart from one another in the second direction DR2, and a second connecting electrode portion 240c that is connected to all of the second divided electrode portions 240pp1 and 240pp2 and that overlaps with the second area SMA.

The second divided electrode portions 240pp1 and the second divided electrode portions 240pp2 may be spaced apart from each other with the second area SMA therebetween. The second divided electrode portions 240pp1 may be spaced apart from one another in the second direction DR2, and the second divided electrode portions 240pp2 may be spaced apart from one another in the second direction DR2.

The first connecting electrode portion 230c may be insulated from the second connecting electrode portion 240c, and may cross the second connecting electrode portion 240c. The second connecting electrode portion 240c may include connecting pattern portions 240cp and bridge patterns 240bp. The connecting pattern portions 240cp may be disposed at (e.g., in or on) the same layer as that of the first connecting electrode portion 230c. The connecting pattern portions 240cp may be spaced apart from each other with the first connecting electrode portion 230c therebetween. The bridge patterns 240bp may be disposed at (e.g., in or on) a layer different from the layer at (e.g., in or on) which the first connecting electrode portion 230c is disposed. The bridge patterns 240bp may be insulated from the first connecting electrode portion 230c, and may cross the first connecting electrode portion 230c.

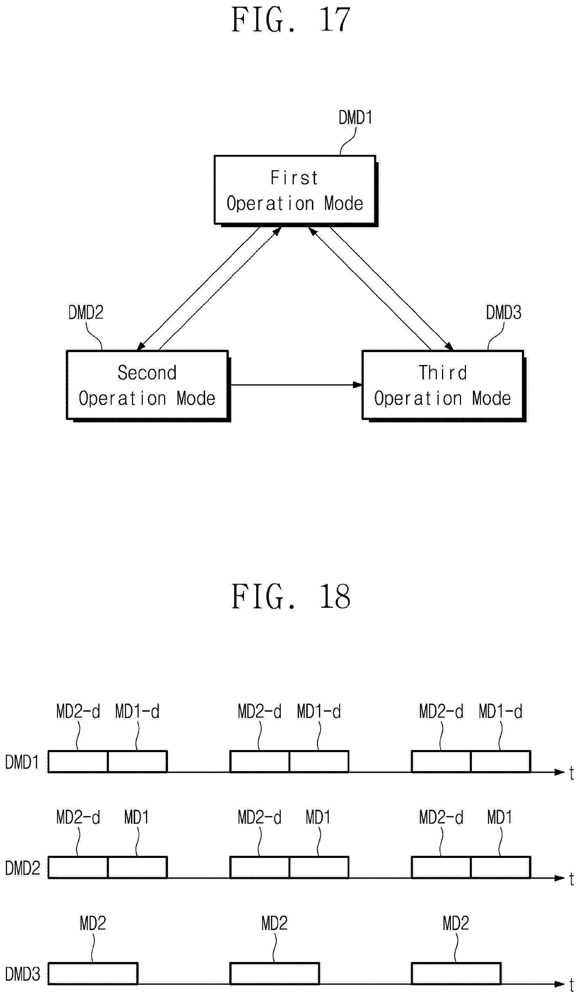

FIG. 17 is a view illustrating operation of the sensor driver 200C according to an embodiment of the present disclosure.

Referring to FIGS. 6 and 17, the sensor driver 200C may selectively operate in a first operation mode DMD1, a second operation mode DMD2, and a third operation mode DMD3.

The first operation mode DMD1 may be referred to as a touch and pen standby mode, the second operation mode DMD2 may be referred to as a touch activation and pen standby mode, and the third operation mode DMD3 may be referred to as a pen activation mode. The first operation mode DMD1 may be a mode for waiting for the first input 2000 and the second input 3000. The second operation mode DMD2 may be a mode for sensing the first input 2000, and waiting for the second input 3000. The third operation mode DMD3 may be a mode for sensing the second input 3000.

In an embodiment of the present disclosure, the sensor driver 200C may first operate in the first operation mode DMD1. When the first input 2000 is sensed in the first operation mode DMD1, the sensor driver 200C may be switched (e.g., changed) to the second operation mode DMD2. As another example, when the second input 3000 is sensed in the first operation mode DMD1, the sensor driver 200C may be switched (e.g., changed) to the third operation mode DMD3.

In an embodiment of the present disclosure, when the second input 3000 is sensed in the second operation mode DMD2, the sensor driver 200C may be switched to the third operation mode DMD3. When the first input 2000 is released (e.g., not sensed) in the second operation mode DMD2, the sensor driver 200C may be switched to the first operation mode DMD1. When the second input 3000 is released (e.g., not sensed) in the third operation mode DMD3, the sensor driver 200C may be switched to the first operation mode DMD1.

FIG. 18 is a view illustrating an operation of the sensor driver 200C according to an embodiment of the present disclosure.

Referring to FIGS. 6, 17, and FIG. 18, operations in the first to third operation modes DMD1, DMD2, and DMD3 are illustrated in order of time t.

In the first operation mode DMD1, the sensor driver 200C may repeatedly operate in an order of a second mode MD2-d and a first mode MD1-d. During the second mode MD2-d, the sensor layer 200 may be scan driven to detect the second input 3000. During the first mode MD1-d, the sensor layer 200 may be scan driven to detect the first input 2000. Although FIG. 18 illustrates an example in which the sensor driver 200C operates in the first mode MD1-d sequentially after the second mode MD2-d, the sequence is not limited thereto.

In the second operation mode DMD2, the sensor driver 200C may repeatedly operate in an order of a second mode MD2-d and a first mode MD1. During the second mode MD2-d, the sensor layer 200 may be scan driven to detect the second input 3000. During the first mode MD1, the sensor layer 200 may be scan driven to detect the coordinates by the first input 2000.

In the third operation mode DMD3, the sensor driver 200C may operate in a second mode MD2. During the second mode MD2, the sensor layer 200 may be scan driven to detect the coordinates by the second input 3000. In the third operation mode DMD3, the sensor driver 200C may not operate in the first mode MD1-d or MD1 until the second input 3000 is released (e.g., not sensed).

Referring to FIG. 8 together, in the first mode MD1-d and the first mode MD1, both the third electrodes 230 and the fourth electrodes 240 may be grounded, or may receive a constant voltage. As another example, in the first mode MD1-d and the first mode MD1, both the third electrodes 230 and the fourth electrodes 240 may be floated (e.g., electrically floated). As another example, in the first mode MD1-d and the first mode MD1, a signal having the same phase as that of a transmission signal provided to the first electrodes 210 may be applied to the third electrodes 230 and the fourth electrodes 240. In this case, introduction of a touch noise through the third electrodes 230 and the fourth electrodes 240 may be prevented or substantially prevented.

In the second mode MD2-d and the second mode MD2, first ends of the third electrodes 230 and the fourth electrodes 240 may all be floated. In addition, in the second mode MD2-d and the second mode MD2, second ends of the third electrodes 230 and the fourth electrodes 240 may all be grounded or floated. Accordingly, a compensation for a sensing signal may be maximized or increased by a coupling between the first electrodes 210 and the third electrodes 230 and a coupling between the second electrodes 220 and the fourth electrodes 240.

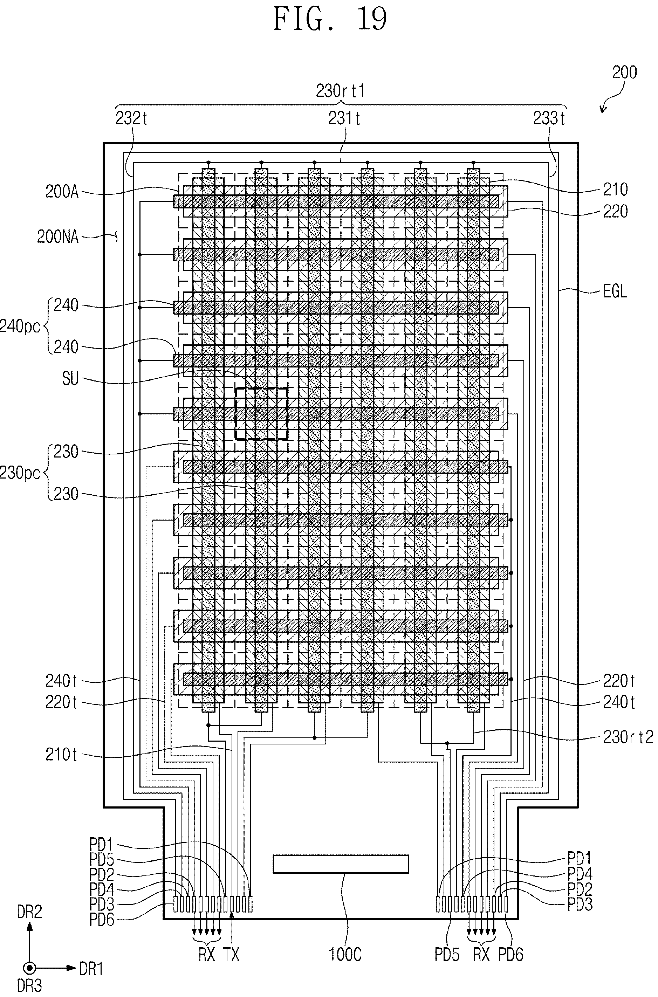

FIG. 19 is a view illustrating a first mode MD1-d and MD1 according to an embodiment of the present disclosure.

Referring to FIGS. 6, FIG. 18, and 19, the first mode MD1-d of the first operation mode DMD1 and the first mode MD1 of the second operation mode DMD2 may include a mutual capacitance detection mode. FIG. 19 is a view illustrating the mutual capacitance detection mode in the first mode MD1-d of the first operation mode DMD1 and the first mode MD1 of the second operation mode DMD2.

In the mutual capacitance detection mode, the sensor driver 200C may sequentially provide a transmission signal TX to the first electrodes 210, and may detect the coordinates of the first input 2000 using a reception signal RX detected through the second electrodes 220. For example, the sensor driver 200C may calculate the input coordinates by sensing a change in a mutual capacitance between the first electrodes 210 and the second electrodes 220. As another example, the sensor driver 200C may sequentially provide the transmission signal TX to the second electrodes 220, and may detect the coordinates of the first input 2000 using a reception signal RX detected through the first electrodes 210.

FIG. 19 illustrates an example in which the transmission signal TX is provided to one first electrode 210 and the reception signal RX is output from the second electrodes 220. The sensor driver 200C may detect the input coordinates of the first input 2000 by sensing a change in a capacitance between the first electrode 210 and each of the second electrodes 220.

In an embodiment of the present disclosure, the transmission signal TX may be sequentially provided to the second electrodes 220, and the reception signal RX may be output from the first electrodes 210. In an embodiment of the present disclosure, one or more transmission signal TX having different frequencies or waveforms from each other may be concurrently (e.g., simultaneously or substantially simultaneously) output to the first electrodes 210 or the second electrodes 220, and the reception signal RX may be output from the first electrodes 210 or the second electrodes 220.

In an embodiment of the present disclosure, at least one of the first mode MD1-d of the first operation mode DMD1 and/or the first mode MD1 of the second operation mode DMD2 may further include a self-capacitance detection mode. In the self-capacitance detection mode, the sensor driver 200C may calculate input coordinates by outputting driving signals to the first electrodes 210 and the second electrodes 220, and sensing a change in the capacitance of each of the first electrodes 210 and the second electrodes 220.

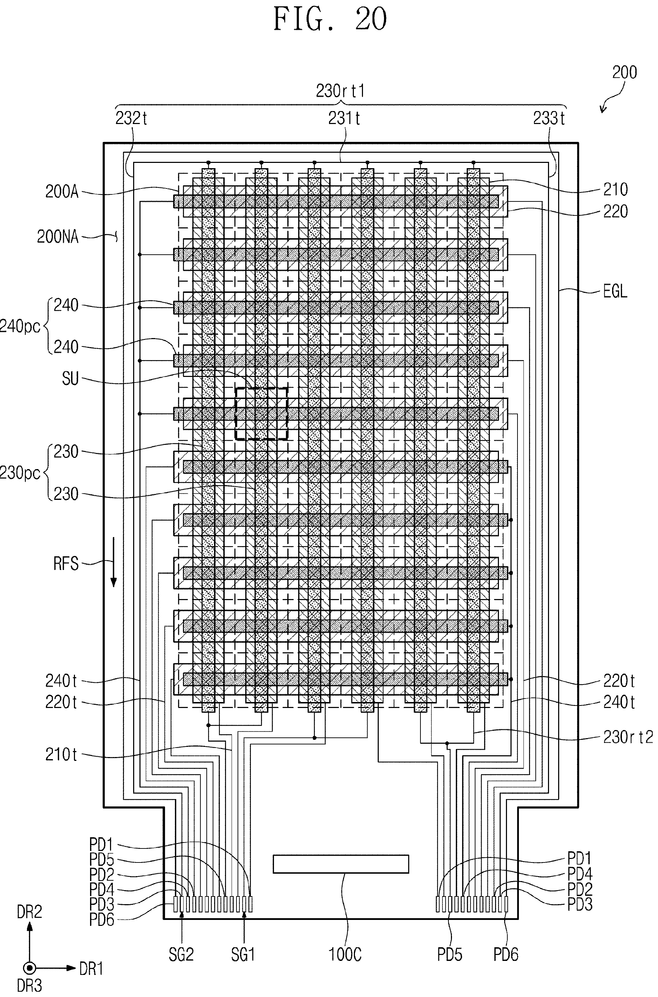

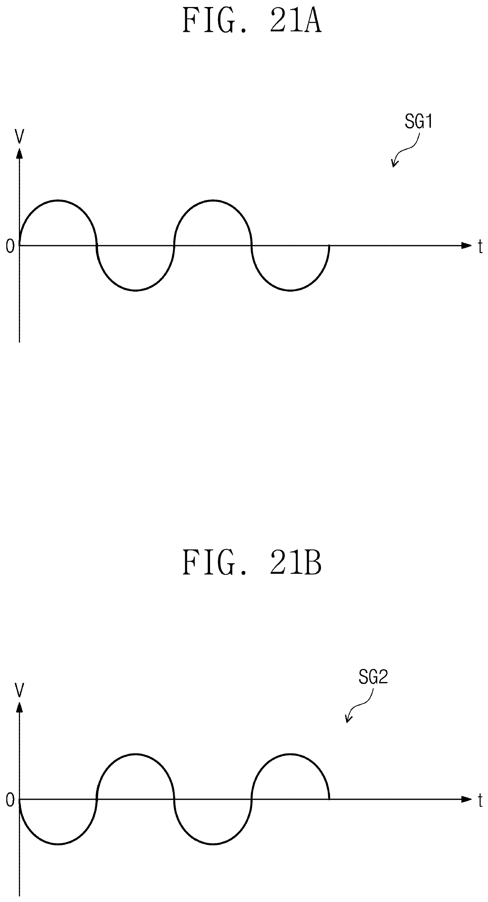

FIG. 20 is a view illustrating a second mode MD2 and MD2-d according to an embodiment of the present disclosure. For example, FIG. 20 may illustrate a charging operation mode of the second mode MD2 and MD2-d according to an embodiment of the present disclosure. FIG. 21A is a graph depicting a waveform of a first signal SG1 according to an embodiment of the present disclosure. FIG. 21B is a graph depicting a waveform of a second signal SG2 according to an embodiment of the present disclosure.

Referring to FIGS. 20, 21A, and 21B, the second mode MD2 and MD2-d may include the charging operation mode. The charging operation mode may include a searching charging operation mode and a tracking charging operation mode. The searching charging operation mode may be omitted as needed or desired.

The searching charging operation mode may be an operation mode before a position of the pen PN is sensed. Accordingly, the first signal SG1 or the second signal SG2 may be sequentially provided to all channels included in the sensor layer 200. In other words, in the searching charging operation mode, the whole area of the sensor layer 200 may be sequentially scanned. When the pen PN is sensed in the searching charging operation mode, the sensor layer 200 may be driven in the tracking charging operation mode. For example, in the tracking charging operation mode, the sensor driver 200C may sequentially output the first signal SG1 and the second signal SG2 to the area overlapping with a point where the pen PN is sensed, rather than to the whole sensor layer 200.

In the charging operation mode, the sensor driver 200C may apply the first signal SG1 to one of the third pads PD3 or the fifth pads PD5, and may apply the second signal SG2 to another pad. The second signal SG2 may be an inverse signal of the first signal SG1. For example, the first signal SG1 may be a sinusoidal signal.

Because the first signal SG1 and the second signal SG2 are applied to at least two pads, a current RFS may have a current path to flow through one pad to another pad. In addition, because the first signal SG1 and the second signal SG2 may be sinusoidal signals having an inverse phase relationship with each other, a direction of the current RFS may be periodically varied. In an embodiment of the present disclosure, the first signal SG1 and the second signal SG2 may be square-wave signals having an inverse phase relationship with each other.

When the first signal SG1 and the second signal SG2 have an inverse phase relationship with each other, a noise caused in the display layer 100 (e.g., refer to FIG. 5) by the first signal SG1 may be cancelled out by a noise caused by the second signal SG2. Accordingly, a flicker phenomenon may not occur in the display layer 100, and a display quality of the display layer 100 may be improved.

In an embodiment of the present disclosure, the first signal SG1 may be a sinusoidal signal. However, the present disclosure is not limited thereto, and the first signal SG1 may be a square-wave signal. The second signal SG2 may have a constant voltage (e.g., a predetermined constant voltage). For example, the second signal SG2 may be a ground voltage. In other words, a pad to which the second signal SG2 is applied may be regarded as being grounded. Even in this case, the current RFS may flow from one pad to another pad. In addition, even though the other pad is grounded, a direction of the current RFS may be periodically varied, because the first signal SG1 is a sinusoidal signal or a square-wave signal.

FIG. 20 illustrates an example in which the second signal SG2 is provided to one third pad PD3 connected with one first loop trace line 230rt1, and the first signal SG1 is provided to one fifth pad PD5 connected with the third electrode 230. The current RFS may flow along the current path defined by the fifth pad PD5, the second loop trace line 230rt2 connected to the fifth pad PD5, the third electrode 230, a portion of the first loop trace line 230rt1 connected to the third pad PD3, and the third pad PD3. The current path may have a coil shape. Accordingly, in the charging operation mode of the second mode MD2 and MD2-d, the resonance circuit of the pen PN may be charged by the current path.

According to some embodiments of the present disclosure, a current path having a loop coil pattern may be implemented by the components included in the sensor layer 200. Accordingly, the electronic device 1000 (e.g., refer to FIG. 2A) may charge the pen PN using the sensor layer 200. Thus, a component having a coil for charging the pen PN may not be separately added, so that an increase in the thickness and the weight of the electronic device 1000 and a decrease in the flexibility of the electronic device 1000 due to the addition of a separate component may not occur.

In the charging operation mode, the first electrodes 210, the second electrodes 220, and the fourth electrodes 240 may be grounded or electrically floated, or may receive a constant voltage. In more detail, the first electrodes 210, the second electrodes 220, and the fourth electrodes 240 may all be floated. In this case, the current RFS may not flow to the first electrodes 210, the second electrodes 220, and the fourth electrodes 240.

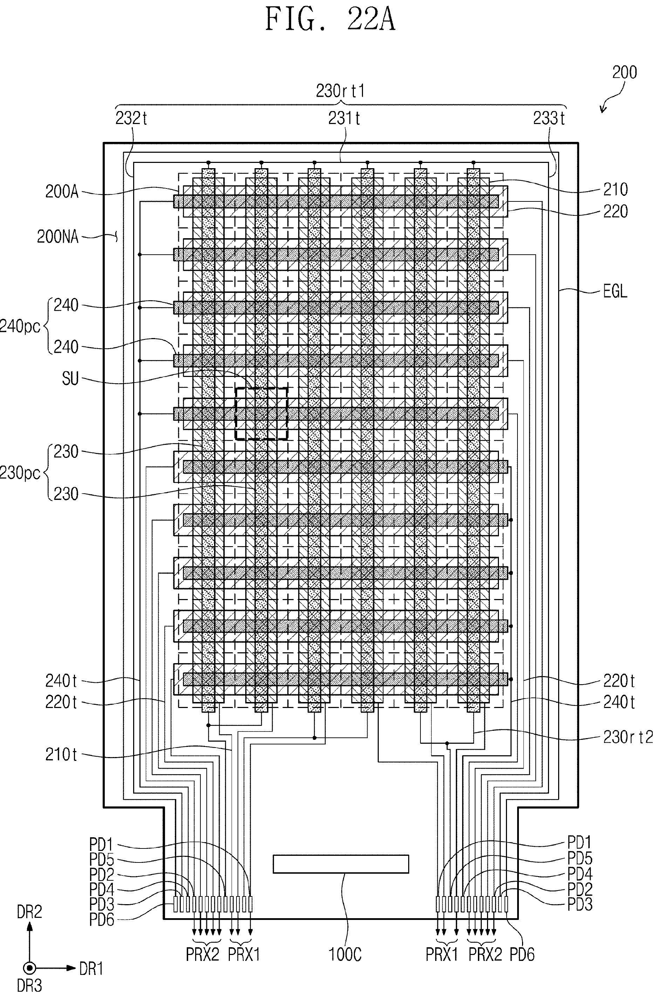

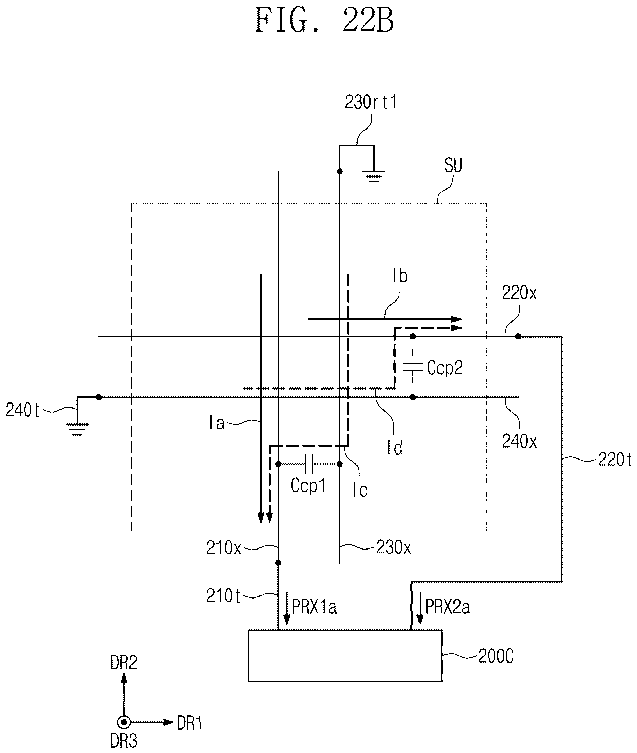

FIG. 22A is a view illustrating a second mode MD2 and MD2-d according to an embodiment of the present disclosure. FIG. 22B is a view illustrating the second mode MD2 and MD2-d based on one sensing unit SU according to an embodiment of the present disclosure.

Referring to FIGS. 22A and 22B, the second mode MD2 and MD2-d may include a charging operation mode and a pen sensing operation mode. FIGS. 22A and 22B are views illustrating the pen sensing operation mode.

Referring to FIG. 22A, in the pen sensing operation mode, first reception signals PRX1 may be output from the first electrodes 210, and second reception signals PRX2 may be output from the second electrodes 220. In FIG. 22B, one sensing unit SU through which first to fourth induced currents Ia, Ib, Ic, and Id generated by the pen PN flow is illustrated.

Referring to FIGS. 22A and 22B, in an embodiment of the present disclosure, routing directions of one electrode and another electrode of the sensor layer 200 that overlap with each other may be different from each other. For example, the routing direction of a first electrode 210x and the routing direction of a third electrode 230x may be different from each other. In addition, the routing direction of a second electrode 220x and the routing direction of a fourth electrode 240x may be different from each other. For example, in FIG. 22B, the first electrode 210x and the first trace line 210t may be connected with each other on the lower side of the sensing unit SU, and the third electrode 230x and the first loop trace line 230rt1 may be connected with each other on the upper side of the sensing unit SU. The second electrode 220x and the second trace line 220t may be connected with each other on the right side of the sensing unit SU, and the fourth electrode 240x and the auxiliary trace line 240t may be connected with each other on the left side of the sensing unit SU.

The RLC resonance circuit of the pen PN may emit a magnetic field having a resonant frequency while discharging charged charges. Due to the magnetic field provided by the pen PN, the first induced current Ia may be generated in the first electrode 210x, and the second induced current Ib may be generated in the second electrode 220x. In addition, the third induced current Ic may be generated in the third electrode 230x, and the fourth induced current Id may be generated in the fourth electrode 240x.

A first coupling capacitor Ccp1 may be formed between the third electrode 230x and the first electrode 210x, and a second coupling capacitor Ccp2 may be formed between the fourth electrode 240x and the second electrode 220x. The third induced current Ic may be transferred to the first electrode 210x through the first coupling capacitor Ccp1, and the fourth induced current Id may be transferred to the second electrode 220x through the second coupling capacitor Ccp2.

The sensor driver 200C may receive a first reception signal PRX1a based on the first induced current Ia and the third induced current Ic from the first electrode 210x, and may receive a second reception signal PRX2a based on the second induced current Ib and the fourth induced current Id from the second electrode 220x. The sensor driver 200C may detect the input coordinates of the pen PN based on the first reception signal PRX1a and the second reception signal PRX2a.

The sensor driver 200C may receive the first reception signal PRX1a from the first electrode 210x, and may receive the second reception signal PRX2a from the second electrode 220x. In this case, first ends of the third electrode 230x and the fourth electrode 240x may all be floated. Accordingly, a compensation for a sensing signal may be maximized or increased by the coupling between the first electrode 210x and the third electrode 230x and the coupling between the second electrode 220x and the fourth electrode 240x.

In addition, second ends of the third electrode 230x and the fourth electrode 240x may be grounded or floated. Accordingly, the third induced current Ic and the fourth induced current Id may be sufficiently transferred to the first electrode 210x and the second electrode 220x by the coupling between the first electrode 210x and the third electrode 230x and the coupling between the second electrode 220x and the fourth electrode 240x, respectively.

As described above, a portion and another portion of the third electrode spaced apart from each other with the second area therebetween may not be electrically isolated from each other, even though the second area overlapping with the sensing area and having a higher transmittance than that of the first area is provided in the sensor layer. In addition, a portion and another portion of the fourth electrode spaced apart from each other with the second area therebetween may not be electrically isolated from each other. Accordingly, a portion of each of the first to fourth electrodes of the sensor layer may not be dummy patterned. As a result, a sensitivity of the sensor layer may be improved.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

Embodiments are set out in the following clauses:
Clause 1. An electronic device comprising:
   a display panel in which a first area and a second area having a higher transmittance than that of the first area are defined, the display panel including a display layer and a sensor layer disposed on the display layer; and
   a processor configured to control operation of the display panel,
   wherein the sensor layer includes:
      a first electrode configured to overlap the first area and the second area;
      a second electrode configured to cross the first electrode and overlap the first area and the second area;
      a third electrode configured to overlap the first electrode and overlap the first area and the second area; and
      a fourth electrode configured to cross the third electrode and overlap the first area and the second area,
      wherein the first electrode includes a first sensing pattern, a second sensing pattern, a third sensing pattern, a plurality of first bridge patterns connected to the first sensing pattern and the second sensing pattern and arranged in a first direction, and a plurality of second bridge patterns connected to the second sensing pattern and the third sensing pattern and arranged in the first direction, and
      wherein the number of the plurality of first bridge patterns is greater than the number of the plurality of second bridge patterns.
Clause 2. The electronic device of clause 1, wherein at least a portion of each of the second sensing pattern and the third sensing pattern overlaps the second area, and
   wherein the plurality of first bridge patterns and the plurality of second bridge patterns do not overlap the second area.
Clause 3. The electronic device of clause 1 or clause 2, wherein each of the first electrode, the second electrode, the third electrode, and the fourth electrode includes a first mesh structure configured to overlap the first area and a second mesh structure configured to overlap the second area, and
   wherein the first mesh structure has a higher density than the second mesh structure.
Clause 4. The electronic device of any of clauses 1 to 3, wherein the fourth electrode includes a plurality of patterns spaced apart from one another in the first direction, a first-type bridge pattern connected to two adjacent patterns among the plurality of patterns, and a second-type bridge pattern connected to two other adjacent patterns among the plurality of patterns, and
   wherein the first-type bridge pattern has a shape different from a shape of the second-type bridge pattern.
Clause 5. The electronic device of clause 4, wherein the first-type bridge pattern overlaps the first area, and the second-type bridge pattern overlaps the second area, and
   wherein one pattern connected to the first-type bridge pattern among the plurality of patterns has a smaller maximum width in a second direction crossing the first direction than one pattern connected to the second-type bridge pattern among the plurality of patterns.
Clause 6. The electronic device of any of clauses 1 to 5, wherein the third electrode includes a plurality of first divided electrode portions spaced apart from one another in the first direction and a first connecting electrode portion connected to all of the plurality of first divided electrode portions and configured to overlap the second area,
   wherein the fourth electrode includes a plurality of second divided electrode portions spaced apart from one another in a second direction crossing the first direction and a second connecting electrode portion connected to all of the plurality of second divided electrode portions and configured to overlap the second area, and
   wherein the first connecting electrode portion and the second connecting electrode portion are insulated from each other and cross each other.
Clause 7. The electronic device of any of clauses 1 to 6, wherein the third electrode includes X first divided electrodes (X being an integer of 2 or more) spaced apart from one another in the first direction,
   wherein the fourth electrode includes Y second divided electrodes (Y being an integer of 2 or more) spaced apart from one another in a second direction crossing the first direction, and
   wherein in X * Y intersection areas, the third electrode and the fourth electrode are insulated from each other and cross each other.

## Claims

1. An electronic device (1000) comprising:
a display panel (DP) having a first area (MA), and a second area (SMA) having a higher transmittance than that of the first area (MA), the display panel (DP) comprising a display layer (100), and a sensor layer (200) on the display layer (100); and
an electronic module (ETM) under the display panel (DP) to overlap with the second area (SMA),
wherein the sensor layer (200) comprises:
a plurality of first electrodes (210) along a first direction (D1);
a plurality of second electrodes (220) along a second direction (D2) crossing the first direction (D1);
a plurality of third electrodes (230) along the first direction (D1), and overlapping with the plurality of first electrodes (210); and
a plurality of fourth electrodes (240) along the second direction (D2), and overlapping with the plurality of second electrodes (220), and
wherein in the second area (SMA), a third electrode (230) among the plurality of third electrodes (230) and a fourth electrode (240) among the plurality of fourth electrodes (240) are insulated from each other and cross each other.

2. The electronic device (1000) of claim 1, wherein the fourth electrode (240) among the plurality of fourth electrodes (240) comprises:
a plurality of patterns (241S) spaced from one another in the first direction (D1);
a first-type bridge pattern (242S1) connected to two adjacent patterns (241S1) among the plurality of patterns (241S1); and
a second-type bridge pattern (242S2) connected to two other adjacent patterns (241S2) among the plurality of patterns (241S), and
wherein the first-type bridge pattern (242S1) has a shape different from a shape of the second-type bridge pattern (242S2).

3. The electronic device (1000) of claim 2, wherein the first-type bridge pattern (242S1) overlaps with the first area (MA), and the second-type bridge pattern (242S2) overlaps with the second area (SMA).

4. The electronic device (1000) of claim 2 or claim 3, wherein one pattern (241S1) connected to the first-type bridge pattern (242S1) among the plurality of patterns (242S) has a smaller maximum width (241WT1) in the second direction (D2) than that of one pattern (241S2) connected to the second-type bridge pattern (242S2) among the plurality of patterns (242S).

5. The electronic device (1000) of any preceding claim, wherein each of the plurality of first electrodes (210) comprises:
a plurality of sensing patterns (211S) spaced from one another in the second direction (D2); and
a plurality of bridge patterns (212S) electrically connected to the plurality of sensing patterns (211S), and
wherein the plurality of bridge patterns (212S) do not overlap with the second area (SMA).

6. The electronic device (1000) of any preceding claim, wherein one first electrode (210) among the plurality of first electrodes (210) comprises:
a first sensing pattern (211S1), a second sensing pattern (211S2), and a third sensing pattern (211S3) spaced from one another in the second direction (D2);
a plurality of first bridge patterns (212S1) connected to the first sensing pattern (211S1) and the second sensing pattern (211S2), and located in the first direction (D1); and
a plurality of second bridge patterns (212S2) connected to the second sensing pattern (211S2) and the third sensing pattern (211S3), and located in the first direction (D1), and
wherein a number of the plurality of first bridge patterns (212S1) is greater than a number of the plurality of second bridge patterns (212S2).

7. The electronic device (1000) of claim 6, wherein at least a portion of each of the second sensing pattern (211S2) and the third sensing pattern (211S3) overlaps with the second area (SMA).

8. The electronic device (1000) of claim 6 or claim 7, wherein the plurality of first bridge patterns (212S1) and the plurality of second bridge patterns (212S2) do not overlap with the second area (SMA).

9. The electronic device (1000) of any preceding claim, wherein each of the plurality of third electrodes (230) comprises a plurality of first divided electrodes (230-dps) spaced from one another in the first direction (D1),
wherein each of the plurality of fourth electrodes (240) comprises a plurality of second divided electrodes (240-dps) spaced apart from one another in the second direction (D2), and
wherein each of first divided electrodes (230-dps) overlapping with the second area (SMA) among the plurality of first divided electrodes (230-dps) is insulated from second divided electrodes (240-dps) overlapping with the second area (SMA) among the plurality of second divided electrodes (240dps), and crosses the second divided electrodes (240dps) overlapping with the second area (SMA).

10. The electronic device (1000) of any preceding claim, wherein the third electrode (230) among the plurality of third electrodes (230) comprises:
a plurality of first divided electrode portions (230pp1, 230pp2) spaced from one another in the first direction (D1); and
a first connecting electrode portion (230c) connected to all of the plurality of first divided electrode portions (230pp1, 230pp2), and overlapping with the second area (SMA),
wherein the fourth electrode (240) among the plurality of fourth electrodes (240) comprises:
a plurality of second divided electrode portions (240pp1, 240pp2) spaced from one another in the second direction (D2); and
a second connecting electrode portion (240c) connected to all of the plurality of second divided electrode portions (240pp1, 240pp2), and overlapping with the second area (SMA), and
wherein the first connecting electrode portion (230c) and the second connecting electrode portion (240c) are insulated from each other and cross each other.

11. The electronic device (1000) of any preceding claim, wherein the sensor layer (200) further comprises:
a plurality of first trace lines (210t) electrically connected to the plurality of first electrodes (210) in a one-to-one correspondence;
a plurality of second trace lines (220t) electrically connected to the plurality of second electrodes (220) in a one-to-one correspondence;
a first loop trace line (230rt1) connected to all of the plurality of third electrodes (230);
a plurality of second loop trace lines (230rt2) electrically connected to the plurality of third electrodes (230); and
an auxiliary trace line (240t) connected to the plurality of fourth electrodes (240).

12. The electronic device (1000) of any preceding claim, wherein each of the plurality of first electrodes (210), the plurality of second electrodes (220), the plurality of third electrodes (230), and the plurality of fourth electrodes (240) comprises a first mesh structure (MSS1) overlapping with the first area (MA), and a second mesh structure (MSS2) overlapping with the second area (SMA), and
wherein the first mesh structure (MSS1) has a higher density than that of the second mesh structure (MSS2).

13. The electronic device (1000) of claim 12, wherein the display layer (100) comprises a plurality of emissive areas (PXA),
wherein the plurality of emissive areas (PXA) comprises a plurality of first-type emissive areas (PXAT1) overlapping with the first area (MA), and a plurality of second-type emissive areas (PXAT2) overlapping with the second area (SMA),
wherein the first mesh structure (MSS1) comprises a plurality of first openings (MOP1) overlapping with the plurality of first-type emissive areas (PXAT1) in a one-to-one correspondence,
wherein the second mesh structure (MSS2) comprises a plurality of second openings (MOP2), and a plurality of transmissive openings (TPA), and
wherein each of the plurality of second openings (MOP2) overlaps with n second-type emissive areas (PXAT2) among the plurality of second-type emissive areas (PXAT2), where n is an integer of 1 or more.
